# EUROPEAN PATENT APPLICATION

(11) **EP 3 817 522 A1**
(43) Date of publication of application: **05.05.2021**
(21) Application number: 19825663.8
(22) Date of filing: 30.05.2019
(51) Int. Cl.: H05K 3/18, H05K 3/38

(54) **MULTILAYER BODY FOR PRINTED WIRING BOARDS AND PRINTED WIRING BOARD USING SAME**

(30) Priority: 26.06.2018 JP 2018120977
(71) Applicant: DIC Corporation, Tokyo 174-8520 (JP)
(72) Inventor: FUKAZAWA Norimasa, Takaishi-shi, Osaka 592-0001 (JP); FUJIKAWA Wataru, Takaishi-shi, Osaka 592-0001 (JP); SHIRAKAMI Jun, Takaishi-shi, Osaka 592-0001 (JP)
(74) Representative: Beckmann, Claus
(86) International application number: PCT/JP2019/021514
(87) International publication number: WO 2020/003880

(57) **Abstract**

The present invention provides a multilayer body for printed wiring boards including a metal particle layer (M1) and a photosensitive resin layer (R) that are sequentially laminated on an insulating substrate (A), or a multilayer body for printed wiring boards including a primer layer (B), a metal particle layer (M1), and a photosensitive resin layer (R) that are sequentially laminated on an insulating substrate (A). The multilayer body for printed wiring boards enables to obtain wiring having high adhesion between the substrate and a conductor circuit, less undercuts, and a rectangular cross-sectional shape preferred as circuit wiring without requiring surface roughening by means of chromic acid or permanganic acid, formation of a surface modified layer using alkali, and a use of a vacuum device.

## Description

### Technical Field

The present invention relates to a multilayer body for printed wiring boards and a printed wiring board using the same .

### Background Art

The printed wiring board is a board in which a metal layer of a circuit pattern is formed on a surface of an insulating substrate. In recent years, with the demand for smaller and lighter electronic device products, there is a demand for thinner printed wiring boards (films) and higher resolution of circuit wiring. In the related art, as a method for producing the circuit wiring, a subtractive method has been widely used, in which an etching resist having a circuit pattern shape is formed on a surface of a copper layer formed on the insulating substrate and an unnecessary non-circuit portion of the copper layer is etched to form copper wiring. However, in the subtractive method, there are problems in that copper at the bottom tail of the wiring is likely to remain, and if a distance between the wiring is shortened because of high density of the circuit wiring, short circuiting and insulation reliability between the wiring are poor. Further, if etching is further performed for the purpose of preventing short circuiting or improving insulation reliability, an etching solution may flow into under the resist, resulting in side etching. As a result, a width of the cross-section of the wiring becomes narrow. In particular, in a case where regions having a different wiring density coexist, there is a problem in that fine wiring present in the region having a low wiring density disappears if the etching is performed. In addition, a cross-section of the wiring obtained by the subtractive method does not have a rectangular shape, but has a trapezoidal or triangular shape with the bottom widened to a substrate. Accordingly, a width of the wiring is different in the thickness direction, which is problematic as an electric transmission path.

A semi-additive method is suggested as a method for solving the problems and fabricating a fine wiring circuit. In the semi-additive method, a conductive seed layer is formed on the insulating substrate, and a plating resist is formed on a non-circuit-formed portion on the seed layer. After a wiring portion is formed by electrolytic plating through the conductive seed layer, the resist is peeled off and the seed layer of the non-circuit-formed portion is removed to form fine wiring. According to the method, since the plating is deposited along the shape of the resist, a cross-sectional shape of the wiring can be made rectangular, and the wiring having the target width can be deposited regardless of the sparseness and density of the pattern. Therefore, the semi-additive method is suitable for forming the fine wiring.

In the semi-additive method, methods are known, in which the conductive seed layer is formed on the insulating substrate by electroless copper plating using a palladium catalyst or electroless nickel plating. In the methods, in a case of a build-up film is used, for example, in order to ensure adhesion between a film substrate and a copper plating film, a surface of the substrate is roughened by using a strong chemical agent such as permanganic acid, which is called desmear roughening. A plating film is formed from the formed voids, thereby ensuring adhesion between the insulating substrate and the plating film utilizing the anchor effect. However, there are problems in that if the surface of the substrate is roughened, it is difficult to form fine wiring, and high frequency transmission characteristics are deteriorated. For the above reason, it has been studied to reduce the degree of roughening, but in a case of low roughening, there is a problem in that the required adhesion strength between the formed wiring and the substrate cannot be obtained.

On the other hand, a technology of forming a conductive seed by electroless nickel plating on a polyimide film is also known. In this case, the polyimide film is immersed in strong alkali to cleave an imide ring of the surface layer and make the film surface hydrophilic, and at the same time, a modified layer into which water permeates is formed and a palladium catalyst is infiltrated into the modified layer to perform electroless nickel plating, thereby forming a nickel seed layer (for example, refer to PTL 1). In this technology, the adhesion strength is obtained as the nickel plating is formed from the modified layer of the polyimide outermost layer. However, since the imide ring is in a cleaved state in the modified layer, there is a problem in that a structure of the film surface layer becomes physically and chemically weak.

On the other hand, as a method of roughening the surface or not forming the modified layer on the surface layer, a method of forming a conductive seed such as nickel or titanium on the insulating substrate by a sputtering method is also known (for example, refer to PTL 2). According to the method, it is possible to form a seed layer without roughening the surface of the substrate, but it is required to use an expensive vacuum device, and there are problems such as a need of a great amount of initial investment, restrictions in a size or shape of the substrate, and complicated processes with low productivity.

As a method for solving the problems of the sputtering method, a method of using a coating layer of a conductive ink containing metal particles as the conductive seed layer is suggested (for example, refer to PTL 3). In this technology, a conductive ink in which metal particles having a particle size of 1 to 500 nm are dispersed is applied on the insulating substrate made of a film or a sheet, heat treatment is performed to fix the metal particles in the applied conductive ink on the insulating substrate as a metal layer and form a conductive seed layer, and plating is further performed on the conductive seed layer.

In PTL 3, pattern forming by the semi-additive method is also suggested. In this method, a conductive ink in which metal particles are dispersed is applied, and is thermally treated to form a conductive seed layer. Thereafter, it is necessary to form a photosensitive resist on the conductive seed layer and expose and develop the resist to thicken the pattern-formed portion by electrolytic plating. In a case of forming a printed wiring board in the related art, a resist is formed on a substrate in which a copper foil is provided on the insulating substrate, or a substrate in which a copper plating film is formed on the substrate. Although semi-additive process is established as a technology for continuous films of copper, a serious of operations of forming a conductive seed layer by applying metal particles and further forming a resist on the layer is not easy even for specialists in plating or specialists in producing a printed wiring board.

### Citation List

### Patent Literature

PTL 1: WO2009/004774
PTL 2: JP-A-9-136378
PTL 3: JP-A-2010-272837

### Summary of Invention

### Technical Problem

A problem to be solved by the present invention is to provide a multilayer body for printed wiring boards which enables formation of the wiring having high adhesion between a substrate and a conductor circuit, less undercuts, and a rectangular cross-sectional shape preferred as circuit wiring without requiring surface roughening by means of chromic acid or permanganic acid and formation of a surface modified layer using alkali, and a use of a vacuum device; and a printed wiring board using the same.

### Solution to Problem

As a result of thorough studies to solve the problems, the inventors of the present invention have found that by using a multilayer body in which a metal particle layer and a photosensitive resin layer (R) are sequentially laminated on an insulating substrate, the specialists in plating or specialists in producing a printed wiring board can easily form a satisfactory metal pattern having high adhesion, even if a surface of the insulating substrate is smooth, and having a rectangular cross-sectional shape with less undercuts without undergoing complicated processes and using a vacuum device, thereby completing the present invention.

That is, the present invention is to provide a multilayer body for printed wiring boards including the metal particle layer (M1) and the photosensitive resin layer (R) that are sequentially laminated on the insulating substrate (A); and a printed wiring board using the same.

Also, provided is a multilayer body for printed wiring boards including a primer layer (B), a metal particle layer (M1) and a photosensitive resin layer (R) that are sequentially laminated on an insulating substrate (A); and a printed wiring board using the same.

### Advantageous Effects of Invention

By using the multilayer body for printed wiring boards of the present invention, it is possible to produce a printed wiring board with circuit wiring having high adhesion on various smooth substrates and a satisfactory rectangular cross-sectional shape without using a vacuum device. Accordingly, by using the technology of the present invention, it is possible to provide a printed wiring board having various shapes, high density in size, and high performance at low cost, and the printed wiring board has high industrial applicability in the field of printed wiring. Further, the printed wiring board produced by using the multilayer body for printed wiring boards of the present invention may be used not only for ordinary printed wiring boards but also for various electronic members having a patterned metal layer on the surface of the substrate. For example, the printed wiring board may be applied to a connector, an electromagnetic wave shield, an antenna such as RFID, a film condenser, and the like. Furthermore, the multilayer body for printed wiring boards of the present invention may be used for decorative plating applications having a patterned metal layer on the substrate having various shapes and sizes.

### Description of Embodiments

The multilayer body for printed wiring boards of the present invention includes a metal particle layer (M1) and a photosensitive resin layer (R) that are sequentially laminated on an insulating substrate (A).

Moreover, the multilayer body for printed wiring boards of a more preferred aspect of the present invention includes a primer layer (B), a metal particle layer (M1), and a photosensitive resin layer (R) that are sequentially laminated on an insulating substrate (A).

Examples of the material of the insulating substrate (A) include a polyimide resin, a polyamidoimide resin, a polyamide resin, a polyethylene terephthalate resin, a polybutylene terephthalate resin, a polyethylene naphthalate resin, a polycarbonate resin, an acrylonitrile-butadiene-styrene (ABS) resin, a polyarylate resin, a polyacetal resin, an acrylic resin such as polymethyl (meth)acrylate, a polyvinylidene fluoride resin, a polytetrafluoroethylene resin, a polyvinyl chloride resin, a polyvinylidene chloride resin, a vinyl chloride resin obtained by graft-copolymerizing an acrylic resin, a polyvinyl alcohol resin, a polyethylene resin, a polypropylene resin, a urethane resin, a cycloolefin resin, polystyrene, a liquid crystal polymer (LCP), a polyetheretherketone (PEEK) resin, polyphenylene sulfide (PPS), polyphenylene sulfone (PPSU), cellulose nanofibers, silicon, silicon carbide, gallium nitride, sapphire, ceramics, glass, diamond-like carbon (DLC), and alumina.

Further, as the insulating substrate (A), a resin substrate containing a thermosetting resin and an inorganic filler may be preferably used. Examples of the thermosetting resin include an epoxy resin, a phenol resin, an unsaturated imide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. On the other hand, examples of the inorganic filler include silica, alumina, talc, mica, aluminum hydroxide, magnesium hydroxide, calcium carbonate, aluminum borate, and borosilicate glass. Each of the thermosetting resins and inorganic fillers may be used alone or two or more thereof may be used in combination.

As the form of the insulating substrate (A), any of a flexible material, a rigid material, and a rigid flexible material may be used. More specifically, a commercially available material molded to have the shape of a film, a sheet or a plate may be used as the insulating substrate (A), or any material molded to have an arbitrary shape from solutions, melted solutions, and dispersions of the resins may be used. Further, the insulating substrate (A) may be a substrate in which the resin material is formed on a conductive material such as metal.

Further, as the form of the insulating substrate (A), through holes penetrating both surfaces of a planar substrate such as a film, a sheet, and a plate may be included, and the substrate may be a multilayer body having a structure of having through holes on outer layers, having a non-through hole as a whole of the multilayer body, and having a hole reaching an inner layer portion. In a case where the insulating substrate (A) has through holes, it is possible to electrically connect both surfaces of the through holes by undergoing the method for producing a printed wiring board described below. Further, in a case where the insulating substrate (A) is a multilayer body having a structure of having a non-through hole and a hole reaching an inner layer portion, it is possible to electrically connect the outer layer and a conductive layer of the inner layer by undergoing the method for producing a printed wiring board described below.

The metal particle layer (M1) is a plating seed used when forming a metal pattern layer (M2) that is a wiring pattern described below by a plating step, at the time of producing a printed wiring board using the multilayer body for printed wiring boards of the present invention. Examples of metal particles constituting the metal particle layer (M1) include metal particles such as gold, platinum, palladium, ruthenium, tin, copper, nickel, iron, cobalt, titanium, indium, and iridium. The metal particles may be used alone or two or more thereof may be used in combination.

Among the metal particles, silver and copper particles are preferably used from a viewpoint of producing the particles easily and the price of materials, and silver particles are particularly preferable, because the surface is not easily oxidized even if the particles are stored in the air, the catalytic activity is high in the plating step described below, and undercuts in the step of etching a seed layer described below can be suppressed.

In a case where silver particles are used as the metal particles constituting the metal particle layer (M1), metal particles other than the silver particles may be used in combination, and a ratio of the metal particles other than the silver particles is not particularly limited, as long as the metal particle layer (M1) can be formed and the plating step can be executed without any problems. 5 parts by mass or less are preferable and 2 parts by mass or less are more preferable relative to 100 parts by mass of the silver particles, from a viewpoint of further improving the etching removability of the non-circuit-formed portion described below.

As a method of forming the metal particle layer (M1), for example, there is a method of applying a metal particle dispersion on the insulating substrate (A). A method of applying the silver particle dispersion is not particularly limited as long as the metal particle layer (M1) can be satisfactorily formed, and various coating methods may be appropriately selected depending on, for eaxmple, the shape, size, and degree of hardness of the insulating substrate (A) to be used. Examples of the specific coating methods include a gravure method, an offset method, a flexo method, a pad printing method, a gravure offset method, a letterpress method, a letterpress reversing method, a screen method, a microcontact method, a reverse method, an air doctor coater method, a blade coater method, an air knife coater method, a squeeze coater method, an impregnation coater method, a transfer roll coater method, a kiss coater method, a cast coater method, a spray coater method, an inkjet method, a die coater method, a spin coater method, a bar coater method, and a dip coater method.

A method of applying the silver particle dispersion on both surfaces of the film-, sheet-, or plate-shaped insulating substrate (A) is not particularly limited, as long as the metal particle layer (M1) can be satisfactorily formed, and the coating method exemplified in the above may be appropriately selected. At this time, the metal particle layer (M1) may be simultaneously formed on both surfaces of the insulating substrate (A), or may be formed on one surface of the insulating substrate (A) and then on the other surface. Further, in a case where the insulating substrate (A) is a three-dimensional molded article, the coating method exemplified in the above may be appropriately selected depending on the size and shape of the molded article. A spray coater method, an inkjet method, and a dip coater method are preferred.

The insulating substrate (A) and the primer layer (B) formed on the insulating substrate (A) may be surface treated before applying the metal particle dispersion, for the purpose of improving coating ability of the metal particle dispersion and improving adhesion of the metal pattern layer (M2) formed in the plating step to the substrate. The surface treatment method of the insulating substrate (A) is not particularly limited as long as the fine pitch pattern forming properties or the signal transmission loss due to rough surface is not problematic because of great roughness of the surface, and various methods are appropriately selected. Examples of the surface treatment method include UV treatment, gas phase ozone treatment, liquid phase ozone treatment, corona treatment, and plasma treatment. One method or a combination of two or more methods may be used for the surface treatment method.

After applying the metal particle dispersion on the insulating substrate (A) or the primer layer (B), the coating film is dried to volatilize the solvent contained in the metal particle dispersion, and the metal particle layer (M1) is formed on the insulating substrate (A) or the primer layer (B) .

The temperature and time for the drying may be appropriately selected depending on the heat resistant temperature of the substrate to be used and the type of the solvent to be used for the metal particle dispersion described below. The temperature is preferably 20°C to 350°C and the time is preferably 1 to 200 minutes. Further, in order to form the metal particle layer (M1) having excellent adhesion to the substrate, the drying temperature is more preferably 0°C to 250°C.

The insulating substrate (A) on which the metal particle layer (M1) is formed or the insulating substrate (A) on which the primer layer (B) is formed may be further annealed, as necessary, after the drying, for the purpose of improving adhesion between the insulating substrate (A) and the metal particle layer (M1) or the primer layer (B) and the metal particle layer (M1). The annealing temperature and time may be appropriately selected depending on the heat resistant temperature of the substrate to be used, the demanded productivity and the like, and the annealing may be performed at 60°C to 350°C for 30 minutes to 2 weeks. In the temperature range of 60°C to 180°C, 30 minutes to 2 weeks is preferable, and in the temperature range of 180°C to 350°C, about 30 minutes to 5 hours is preferable.

The drying may be performed by blowing air, or in particular, may not be performed by blowing air. Further, the drying may be performed in the air, in a substituted atmosphere of an inert gas such as nitrogen and argon, or in an air stream, or may be performed in a vacuum.

In a case where the insulating substrate (A) is a sheet-shaped film, sheet, plate, or three-dimensional molded article, the coating film may be dried by natural drying at the coating place, and additionally, by blowing air or in a dryer such as a constant temperature dryer. In a case where the insulating substrate (A) is a roll film or a roll sheet, the coating film may be dried and baked by continuously moving the roll material in the installed non-heating or heating space after the coating step. As the heating method for drying and baking at this time, for example, a method of using an oven, a hot air type drying furnace, an infrared drying furnace, laser irradiation, microwaves, and light irradiation (flash irradiation device) may be exemplified. The heating methods may be used alone or two or more thereof may be used in combination.

The amount of the metal particle layer (M1) formed on the insulating substrate (A) or the primer layer (B) is preferably 0.01 to 30 g/m², and more preferably 0.01 to 10 g/m². Further, 0.05 to 5 g/m² is still more preferable because the metal pattern layer (M2) is easily formed by the plating step described below and the seed layer removing step by the etching described below is easily performed.

The formation amount of the metal particle layer (M1) may be confirmed by using a conventionally known analysis method such as a fluorescent X-ray method, an atomic absorption method, and an ICP method.

Further, in the step of exposing a circuit pattern on the resist layer described below with active light, for the purpose of suppressing reflection of active light from the metal particle layer (M1), the metal particle layer (M1) may contain a pigment or a dye that absorbs light such as a cyanine compound, a phthalocyanine compound, a dithiol metal complex, a naphthoquinone compound, a diimmonium compound, an azo compound, and graphite or carbon that absorbs the active light as a light absorbing agent within a range in which the metal particle layer (M1) can be formed, the electrolytic plating described below can be carried out without any problems, and the etching removability described below can be obtained. The pigments or dyes may be appropriately selected according to the wavelength of the active light to be used. Further, the pigments or dyes may be used alone or two or more thereof may be used in combination. Further, in order to contain the pigments or dyes in the metal particle layer (M1), the pigments or dyes may be blended into the silver particle dispersion described below.

The metal particle dispersion used for forming the metal particle layer (M1) is a dispersion in which metal particles are dispersed in a solvent. The shape of the silver particles is not particularly limited as long as the particles can satisfactorily form the metal particle layer (M1), and metal particles having various shapes such as a spherical shape, a lens shape, a polyhedral shape, a flat plate shape, a rod shape, and a wire shape may be used. One type of the metal particles having a single shape may be used, or two or more types thereof having different shapes may be used in combination.

In a case where the shape of the metal particles is spherical or polyhedral, the average particle size thereof is preferably 1 to 20,000 nm. Further, in a case where a fine circuit pattern is formed, the homogeneity of the metal particle layer (M1) is further improved, and the removability by an etching solution described below can be further improved. Thus, the average particle size thereof is more preferably 1 to 200 nm and still more preferably 1 to 50 nm. The "average particle size" of the nanometer-sized particles is a volume average value obtained by diluting the metal particles with a good dispersion solvent and measuring by a dynamic light scattering method. The "nanotrac UPA-150" manufactured by Microtrac, Inc. may be used for the measurement.

On the other hand, in a case where the metal particles have a shape such as a lens shape, a rod shape, and a wire shape, the minor axis thereof is preferably 1 to 200 nm, more preferably 2 to 100 nm, and still more preferably 5 to 50 nm.

A main component of the metal particles is preferably silver particles, but as long as the plating step described below is not inhibited and the removability by an etching solution of the metal particle layer (M1) described below are not impaired, a part of silver constituting the metal particles may be substituted with another metal, or a metal component other than silver may be mixed.

Examples of the metal that is substituted or mixed include one or more metal elements selected from the group consisting of gold, platinum, palladium, ruthenium, tin, copper, nickel, iron, cobalt, titanium, indium and iridium.

In a case where silver particles are the main component of the metal particles, the ratio of the metal that is substituted or mixed to the silver particles is preferably 5% by mass or less in the silver particles and more preferably 2% by mass or less from a viewpoint of plating deposit properties of the metal particle layer (M1) and removability by an etching solution.

The metal particle dispersion used for forming the metal particle layer (M1) is prepared by dispersing metal particles in various solvents, and the particle size distribution of the metal particles in the dispersion may be a uniform monodispersion or a mixture of the particles having a size within the average particle size range.

As the solvent used for the dispersion of the metal particles, an aqueous medium or an organic solvent may be used. Examples of the aqueous medium include distilled water, ion-exchanged water, pure water, and ultrapure water. Examples of the organic solvent include an alcohol compound, an ether compound, an ester compound and a ketone compound.

Examples of the alcohol solvent or ether solvent include methanol, ethanol, n-propanol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol, terpineol, dihydroterpineol, 2-ethyl-1,3-hexanediol, ethylene glycol, diethylene glycol, triethylene glycol, polyethylene glycol, propylene glycol, dipropylene glycol, 1,2-butanediol, 1,3-butanediol, 1,4-butanediol, 2,3-butanediol, glycerin, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, and tripropylene glycol monobutyl ether.

Examples of the ketone solvent include acetone, cyclohexanone, and methyl ethyl ketone. Examples of the ester solvent include ethyl acetate, butyl acetate, 3-methoxybutyl acetate, and 3-methoxy-3-methyl-butyl acetate. Further, as the other organic solvent, a hydrocarbon solvent such as toluene, in particular, a hydrocarbon solvent having 8 or more carbon atoms may be exemplified.

Examples of the hydrocarbon solvent having 8 or more carbon atoms include nonpolar solvents such as octane, nonane, decane, dodecane, tridecane, tetradecane, cyclooctane, xylene, mesitylene, ethylbenzene, dodecylbenzene, tetralin, and trimethylbenzenecyclohexane, and the solvents may be used in combination with other solvents, if necessary. Further, a mixed solvent such as mineral spirit or solvent naphtha may be used in combination.

The solvent is not particularly limited, as long as the metal particles are stably dispersed and the metal particle layer (M1) is satisfactorily formed on the insulating substrate (A) or the primer layer (B) formed on the insulating substrate (A) described below. Moreover, the solvent may be used alone or two or more thereof may be used in combination.

The content ratio of the metal particles in the metal particle dispersion may be appropriately adjusted such that the amount of the metal particle layer (M1) formed on the insulating substrate (A) is 0.01 to 30 g/m² by using the various coating methods, and may be adjusted so as to have a viscosity having the optimum coating ability in accordance with the various coating methods. The content ratio is preferably 0.1% to 50% by mass, more preferably 0.5% to 20% by mass, and still more preferably 0.5% to 10% by mass.

In the metal particle dispersion, it is preferable that the metal particles maintain dispersion stability for a long period of time without being aggregated, fused, or precipitated in the various solvents, and the metal particle dispersion preferably contains a dispersant for dispersing the metal particles in the various solvents. As the dispersant, a dispersant having a functional group that coordinates with the metal particles is preferable, and examples of the dispersant include a dispersant having a functional group such as a carboxyl group, an amino group, a cyano group, an acetoacetyl group, a phosphorus atom-containing group, a thiol group, a thiocyanato group, and a glycinato group.

As the dispersant, a commercially available dispersant or an independently synthesized dispersant having a low molecular weight or a high molecular weight may be used, and the dispersant may be appropriately selected depending on the purpose, for example, a solvent that disperses the metal particles or a type of the insulating substrate (A) to which the dispersion of the metal particles is applied. For example, dodecanethiol, 1-octanethiol, triphenylphosphine, dodecylamine, polyethylene glycol, polyvinylpyrrolidone, polyethyleneimine, polyvinylpyrrolidone; fatty acids such as myristic acid, octanoic acid, and stearic acid; and a polycyclic hydrocarbon compound having a carboxyl group such as cholic acid, glycyrrhizic acid, and abietic acid are preferably used. Here, in a case where the metal particle layer (M1) is formed on the primer layer (B) described below, a compound having a reactive functional group [Y] capable of forming a chemical bond with a reactive functional group [X] included in the resin used for the primer layer (B) described below is preferable from a viewpoint of satisfactory adhesion between the two layers.

Examples of the compound having a reactive functional group [Y] include a compound having an amino group, an amide group, an alkylolamide group, a carboxyl group, an anhydrous carboxyl group, a carbonyl group, an acetoacetyl group, an epoxy group, an alicyclic epoxy group, an oxetane ring, a vinyl group, an allyl group, a (meth)acryloyl group, a (blocked) isocyanate group, and an (alkoxy) silyl group, and a silsesquioxane compound. In particular, the reactive functional group [Y] is preferably a basic nitrogen atom-containing group because adhesion between the primer layer (B) and the metal particle layer (M1) can be further improved. Examples of the basic nitrogen atom-containing group include an imino group, a primary amino group, and a secondary amino group.

The basic nitrogen atom-containing group may be present singly or plurally in one molecule of the dispersant. By containing a plurality of basic nitrogen atoms in the dispersant, a part of the basic nitrogen atom-containing groups contributes to dispersion stability of the metal particles through the interaction with the metal particles, and the remaining basic nitrogen atom-containing groups contribute to improvement in adhesion to the insulating substrate (A). Further, in a case where a resin having the reactive functional group [X] is used for the primer layer (B) described below, the basic nitrogen atom-containing group in the dispersant is preferable because the basic nitrogen atom-containing group is capable of forming a chemical bond with the reactive functional group [X] and adhesion of the metal pattern layer (M2) described below to the insulating substrate (A) can be further improved.

The dispersant is preferably a polymeric dispersant because of stability and coating ability of the dispersion of the metal particles and formation of the metal particle layer (M1) showing satisfactory adhesion to the insulating substrate (A), and as the polymeric dispersant, polyalkyleneimine such as polyethyleneimine and polypropyleneimine, and a compound obtained by adding polyoxyalkylene to the polyalkyleneimine are preferable.

As the compound obtained by adding polyoxyalkylene to the polyalkyleneimine may be a compound in which polyethyleneimine and polyoxyalkylene are linearly bonded, or a compound in which polyoxyalkylene is grafted onto the side of the main chain composed of the polyethyleneimine.

Specific examples of the compound obtained by adding polyoxyalkylene to the polyalkyleneimine include a block copolymer of polyethyleneimine and polyoxyethylene, a compound obtained by introducing a polyoxyethylene structure by adding ethylene oxide to a part of the imino group present in the main chain of polyethyleneimine, and a compound obtained by reacting an amino group included in polyalkyleneimine, a hydroxyl group included in polyoxyethylene glycol, and an epoxy group included in an epoxy resin with each other.

Examples of commercially available products of the polyalkyleneimine include "PAO2006W", "PAO306", "PAO318", and "PAO718" of "Epomin (registered trademark) PAO series" manufactured by Nippon Shokubai Co., Ltd.

The number average molecular weight of the polyalkyleneimine is preferably 3,000 to 30,000.

The amount of the dispersant used to disperse the metal particles is preferably 0.01 to 50 parts by mass with respect to 100 parts by mass of the metal particles, preferably 0.1 to 10 parts by mass with respect to 100 parts by mass of the metal particles, because the metal particle layer (M1) showing satisfactory adhesion to the insulating substrate (A) or the primer layer (B) described below can be formed, and more preferably 0.1 to 5 parts by mass, because the plating deposit ability of the metal particle layer (M1) can be further improved.

A method for producing the dispersion of the metal particles is not particularly limited, and the dispersion may be produced by using various methods. For example, metal particles produced by using a gas phase method such as an evaporation method in a low vacuum gas may be dispersed in a solvent, and the dispersion of the metal particles may be directly prepared by reducing a silver compound in a liquid phase . In both the gas phase method and the liquid phase method, the solvent composition of the dispersion at the time of production and the dispersion at the time of coating may be appropriately changed, if necessary, by exchanging a solvent or adding a solvent. Among the gas phase method and the liquid phase method, the liquid phase method may be particularly preferably used because of stability of the dispersion and simplicity of the production process. As the liquid phase method, the dispersion may be produced, for example, by reducing silver ions in the presence of the polymeric dispersant.

The dispersion of the metal particles may be further blended with an organic compound such as a surfactant, a leveling agent, a viscosity adjusting agent, a film forming aid, a defoaming agent and a preservative, if necessary.

Examples of the surfactant include nonionic surfactants such as polyoxyethylene nonylphenyl ether, polyoxyethylene lauryl ether, polyoxyethylene styrylphenyl ether, polyoxyethylene sorbitol tetraoleate, and a polyoxyethylene/polyoxypropylene copolymer; anionic surfactants such as fatty acid salts such as sodium oleate, alkyl sulfate ester salts, alkyl benzene sulfonate salts, alkyl sulfosuccinate salts, naphthalene sulfonate salts, polyoxyethylene alkyl sulfate salts, sodium alkane sulfonate salts, and sodium alkyl diphenyl ether sulfonate salts; and cationic surfactants such as alkylamine salts, alkyltrimethylammonium salts, and alkyldimethylbenzylammonium salts.

As the leveling agent, a general leveling agent may be used, and examples thereof include a silicone-based compound, an acetylene diol-based compound, and a fluorine-based compound.

As the viscosity adjusting agent, a general thickening agent may be used, and examples thereof include an acrylic polymer that can perform thickening by adjusting to alkaline, a synthetic rubber latex, a urethane resin that can perform thickening by the association of molecules, hydroxyethyl cellulose, carboxymethyl cellulose, methyl cellulose, polyvinyl alcohol, water-added castor oil, amide wax, polyethylene oxide, metal soap, and dibenzylidene sorbitol.

As the film forming aid, a general film forming aid may be used, and examples thereof include an anionic surfactant such as dioctyl sulfosuccinate ester soda salts, a hydrophobic nonionic surfactant such as sorbitan monooleate, polyether modified siloxane, and silicone oil.

As the defoaming agent, a general defoaming agent may be used, and examples thereof include a silicone-based defoaming agent, a nonionic surfactant, polyether, a higher alcohol, and a polymeric surfactant.

As the preservative, a general preservative may be used, and examples thereof include an isothiazoline-based preservative, a triazine-based preservative, an imidazole-based preservative, a pyridine-based preservative, an azole-based preservative, and a pyrithione-based preservative.

Moreover, a more preferred aspect of the multilayer body for printed wiring boards of the present invention is a multilayer body in which the primer layer (B), the metal particle layer (M1), and a photosensitive resin layer (R) are sequentially laminated on the insulating substrate (A). The multilayer body for printed wiring boards provided with the primer layer is preferable because adhesion of the metal pattern layer (M2) to the insulating substrate (A) can be further improved.

The primer layer (B) may be formed by applying a primer to a part or the whole surface of the insulating substrate (A) , and removing a solvent such as an aqueous medium and an organic solvent contained in the primer. Here, the primer is a liquid composition used for the purpose of improving adhesion of the metal pattern layer (M2) to the insulating substrate (A), and obtained by dissolving or dispersing various resins described below in a solvent.

A method of applying the primer to the insulating substrate (A) is not particularly limited, as long as the primer layer (B) can be satisfactorily formed, and various coating methods may be appropriately selected depending on, for example, the shape, size, and degree of hardness of the insulating substrate (A) to be used. Examples of the specific coating methods include a gravure method, an offset method, a flexo method, a pad printing method, a gravure offset method, a letterpress method, a letterpress reversing method, a screen method, a microcontact method, a reverse method, an air doctor coater method, a blade coater method, an air knife coater method, a squeeze coater method, an impregnation coater method, a transfer roll coater method, a kiss coater method, a cast coater method, a spray coater method, an inkjet method, a die coater method, a spin coater method, a bar coater method, and a dip coater method.

A method of applying the primer to both surfaces of the film-, sheet-, or plate-shaped insulating substrate (A) is not particularly limited, as long as the primer layer (B) can be satisfactorily formed, and the coating methods exemplified in the above may be appropriately selected. At this time, the primer layer (B) may be simultaneously formed on both surfaces of the insulating substrate (A), or may be formed on one surface of the insulating substrate (A) and then formed on the other surface. Further, in a case where the insulating substrate (A) is a three-dimensional molded article, the coating method exemplified in the above may be appropriately selected depending on the size and shape of the molded article. A spray coater method, an inkjet method, and a dip coater method are preferred.

The insulating substrate (A) may be surface treated before the primer coating for the purpose of improving the coating ability of the primer and adhesion of the metal pattern layer (M2) to the substrate. As the surface treatment method of the insulating substrate (A), the same method as the surface treatment method of forming the metal particle layer (M1) on the insulating substrate (A) may be used.

As a method of forming the primer layer (B) by coating the primer on the surface of the insulating substrate (A) and then removing the solvent contained in the coating layer, for example, a method of drying using a dryer to volatilize the solvent is generally used. The drying temperature may be set to a temperature within a range in which the solvent can be volatilized and there is no an adverse effect on the insulating substrate (A), and either drying at room temperature or drying by heating may be used. The specific drying temperature is preferably 20°C to 350°C and more preferably 60°C to 300°C. Further, the drying time is preferably 1 to 200 minutes and more preferably 1 to 60 minutes.

The drying may be performed by blowing air, or in particular, may not be performed by blowing air. Further, the drying may be performed in the air, in a substituted atmosphere such as nitrogen and argon, or in an air stream, or may be performed in a vacuum.

In a case where the insulating substrate (A) is a sheet-shaped film, sheet, plate, or three-dimensional molded article, the drying may be performed by natural drying at the coating place, and additionally, by blowing air or in a dryer such as a constant temperature dryer. In a case where the insulating substrate (A) is a roll film or a roll sheet, the drying may be performed by continuously moving the roll material in the installed non-heating or heating space after the coating step.

The film thickness of the primer layer (B) may be appropriately selected depending on the specifications and the purpose of the printed wiring board to be produced by using the present invention. The film thickness is preferably 10 nm to 30 µm, more preferably 10 nm to 1 µm, and still more preferably 10 nm to 500 nm because adhesion of the metal pattern layer (M2) to the insulating substrate (A) can be further improved.

In a case where a resin having the reactive functional group [Y] is used for the dispersant of the metal particles, a resin having the reactive functional group [X] having reactivity with the reactive functional group [Y] is preferable as the resin that forms the primer layer (B). Examples of the reactive functional group [X] include an amino group, an amide group, an alkylolamide group, a carboxyl group, an anhydrous carboxyl group, a carbonyl group, an acetoacetyl group, an epoxy group, an alicyclic epoxy group, an oxetane ring, and a vinyl group, an allyl group, a (meth) acryloyl group, a (blocked) isocyanate group, and an (alkoxy)silyl group. Further, a silsesquioxane compound may also be used as the compound for forming the primer layer (B).

In particular, in a case where the reactive functional group [Y] in the dispersant is a basic nitrogen atom-containing group, the resin that forms the primer layer (B) preferably has, as the reactive functional group [X], a carboxyl group, a carbonyl group, an acetoacetyl group, an epoxy group, an alicyclic epoxy group, an alkylolamide group, an isocyanate group, a vinyl group, a (meth) acryloyl group, and an allyl group, because adhesion of the metal pattern layer (M2) to the insulating substrate (A) can be further improved.

Examples of the resin that forms the primer layer (B) include a urethane resin, an acrylic resin, a core-shell type composite resin having a urethane resin as a shell and an acrylic resin as a core, an epoxy resin, an imide resin, an amide resin, a melamine resin, a phenol resin, a urea formaldehyde resin, blocked isocyanate polyvinyl alcohol obtained by reacting polyisocyanate with a blocking agent such as phenol, and polyvinylpyrrolidone. The core-shell type composite resin having a urethane resin as a shell and an acrylic resin as a core is obtained, for example, by polymerizing an acrylic monomer in the presence of the urethane resin. The resins may be used alone or two or more thereof may be used in combination.

Among the resins that form the primer layer (B), a resin that generates a reducing compound by heating is preferable because adhesion of the metal pattern layer (M2) to the insulating substrate (A) can be further improved. Examples of the reducing compound include a phenol compound, an aromatic amine compound, a sulfur compound, a phosphoric acid compound, and an aldehyde compound. Among the reducing compounds, a phenol compound and an aldehyde compound are preferable.

In a case where a resin that generates a reducing compound by heating is used for the primer, a reducing compound such as formaldehyde or phenol is generated in the heating and drying step at the time of forming the primer layer (B). Specific examples of the resin that generates a reducing compound by heating include a resin obtained by polymerizing a monomer containing N-alkylol (meth)acrylamide, a core-shell type composite resin having a urethane resin as a shell and a resin obtained by polymerizing a monomer containing N-alkylol (meth)acrylamide as a core, an urea-formaldehyde-methanol condensate, an urea-melamine-formaldehyde-methanol condensate, polyN-alkoxymethylol (meth)acrylamide, a formaldehyde adduct of poly(meth)acrylamide, a resin that generates formaldehyde by heating such as a melamine resin; a phenol resin, and a resin that generates a phenol compound by heating such as phenol blocked isocyanate. Among the resins, from a viewpoint of improving adhesion, a core-shell type composite resin having a urethane resin as a shell and a resin obtained by polymerizing a monomer containing N-alkylol (meth)acrylamide as a core, a melamine resin, and phenol blocked isocyanate are preferable.

In the present invention, "(meth)acrylamide" means either or both of "methacrylamide" and "acrylamide", and "(meth)acrylic acid" means either or both of "methacrylic acid" and "acrylic acid".

The resin that generates a reducing compound by heating is obtained by polymerizing a monomer having a functional group that generates a reducing compound by heating by a polymerization method such as radical polymerization, anionic polymerization, or cationic polymerization.

Examples of the monomer having a functional group that generates a reducing compound by heating include a N-alkylol vinyl monomer, and specifically, N-methylol (meth) acrylamide, N-methoxymethyl (meth)acrylamide, N-ethoxymethyl (meth)acrylamide, N-propoxymethyl (meth)acrylamide, N-isopropoxymethyl (meth)acrylamide, N-n-butoxymethyl (meth)acrylamide, N-isobutoxymethyl (meth)acrylamide, N-pentoxymethyl (meth)acrylamide, N-ethanol (meth)acrylamide, and N-propanol (meth)acrylamide may be exemplified.

In addition, at the time of producing a resin that generates a reducing compound by the heating, other various types of monomers such as (meth)acrylic acid alkyl ester may be copolymerized with a monomer having a functional group that generates a reducing compound by heating.

In a case where the blocked isocyanate is used as the resin that forms the primer layer (B), an uretdione bond is formed by self-reaction between isocyanate groups, or an isocyanate group and a functional group contained in another component form a chemical bond, thereby forming the primer layer (B). The chemical bond formed at this time may be formed before applying the metal particle dispersion, or may not be formed before applying the metal particle dispersion but formed by heating after applying the metal particle dispersion.

Examples of the blocked isocyanate include those having a functional group formed by blocking an isocyanate group with a blocking agent.

The blocked isocyanate preferably has the functional group in the amount of 350 to 600 g/mol per 1 mol of the blocked isocyanate.

From a viewpoint of improving adhesion, the blocked isocyanate preferably has 1 to 10 functional groups and more preferably 2 to 5 functional groups in one molecule of the blocked isocyanate.

Further, the number average molecular weight of the blocked isocyanate is preferably 1,500 to 5,000 and more preferably 1,500 to 3,000 from a viewpoint of improving adhesion.

Further, the blocked isocyanate preferably has an aromatic ring from a viewpoint of further improving adhesion. Examples of the aromatic ring include a phenyl group and a naphthyl group.

The blocked isocyanate may be produced by reacting a part or all of the isocyanate groups of the isocyanate compound with a blocking agent.

Examples of the isocyanate compound as a raw material of the blocked isocyanate include a polyisocyanate compound having an aromatic ring such as 4,4'-diphenylmethane diisocyanate, 2,4'-diphenylmethane diisocyanate, carbodiimide-modified diphenylmethane diisocyanate, crude diphenylmethane diisocyanate, phenylene diisocyanate, tolylene diisocyanate, and naphthalene diisocyanate; and an aliphatic polyisocyanate compound such as hexamethylene diisocyanate, lysine diisocyanate, cyclohexane diisocyanate, isophorone diisocyanate, dicyclohexylmethane diisocyanate, xylylene diisocyanate, and tetramethyl xylylene diisocyanate or a polyisocyanate compound having an alicyclic structure. Moreover, the biuret, the isocyanurate, and the adduct of the polyisocyanate compound may be exemplified.

Further, examples of the isocyanate compound include those obtained by reacting the polyisocyanate compound exemplified above with a compound having a hydroxyl group or an amino group.

In a case where an aromatic ring is introduced into the blocked isocyanate, it is preferable to use the polyisocyanate compound having an aromatic ring. Among the polyisocyanate compounds having an aromatic ring, 4,4'-diphenylmethane diisocyanate, tolylene diisocyanate, an isocyanurate of 4,4'-diphenylmethane diisocyanate, and an isocyanurate of tolylene diisocyanate are preferable.

Examples of the blocking agent used for producing the blocked isocyanate include a phenol compound such as phenol and cresol; a lactam compound such as ε-caprolactam, δ-valerolactam and γ-butyrolactam; an oxime compound such as formamide oxime, acetaldoxime, acetone oxime, methyl ethyl ketoxime, methyl isobutyl ketoxime, cyclohexanone oxime; 2-hydroxypyridine, butyl cellosolve, propylene glycol monomethyl ether, benzyl alcohol, methanol, ethanol, n-butanol, isobutanol, dimethyl malonate, diethyl malonate, methyl acetoacetate, ethyl acetoacetate, acetylacetone, butyl mercaptan, dodecyl mercaptan, acetanilide, acetamide, succinimide, maleimide, imidazole, 2-methylimidazole, urea, thiourea, ethyleneurea, diphenylaniline, aniline, carbazole, ethyleneimine, polyethyleneimine, 1H-pyrazole, 3-methylpyrazole, and 3,5-dimethylpyrazole. Among the blocking agents, a blocking agent capable of generating an isocyanate group by dissociation when heated at 70°C to 200°C is preferable, and a blocking agent capable of generating an isocyanate group by dissociation when heated at 110°C to 180°C are more preferable. Specifically, a phenol compound, a lactam compound, and an oxime compound are preferable, and in particular, a phenol compound is more preferable because the phenol compound becomes a reducing compound when the blocking agent is eliminated by heating.

As a method of producing the blocked isocyanate, a method of mixing and reacting the previously produced isocyanate compound with the blocking agent, and a method of mixing and reacting the blocking agent with the raw materials used for producing the isocyanate compound may be exemplified.

More specifically, an isocyanate compound having an isocyanate group at the terminal is produced by reacting the polyisocyanate compound with a compound having a hydroxyl group or an amino group, and then the isocyanate compound is mixed and reacted with the blocking agent to produce the blocked isocyanate.

The content ratio of the blocked isocyanate obtained by the method in the resin that forms the primer layer (B) is preferably 50% to 100% by mass and more preferably 70% to 100% by mass.

Examples of the melamine resin include mono- or polymethylol melamine obtained by adding 1 to 6 mol of formaldehyde to 1 mol of melamine; (poly)methylol melamine etherified product (the degree of etherification is optional) such as trimethoxymethylol melamine, tributoxymethylol melamine, and hexamethoxymethylol melamine; and an urea-melamine-formaldehyde-methanol condensate.

Further, in addition to the method of using a resin that generates a reducing compound by heating as described above, a method of adding a reducing compound to the resin may also be exemplified. In this case, examples of the reducing compound to be added include a phenolic antioxidant, an aromatic amine-based antioxidant, a sulfuric antioxidant, a phosphoric acid-based antioxidant, vitamin C, vitamin E, sodium ethylenediamine tetraacetate, sulfite, hypophosphorous acid, hypophosphite, hydrazine, formaldehyde, sodium borohydride, dimethylamine borane, and phenol.

In the present invention, in the method of adding a reducing compound to the resin, electrical characteristics may be deteriorated because low molecular weight components or ionic compounds consequently remain, and accordingly a method of using a resin that generates a reducing compound by heating is more preferable.

The primer used for forming the primer layer (B) preferably contains the resin in the amount of 1% to 70% by mass and more preferably 1% to 20% by mass in the primer, from a viewpoint of coating ability and film forming properties.

In addition, examples of the solvent that may be used for the primer include various organic solvents and aqueous media. Examples of the organic solvent include toluene, ethyl acetate, methyl ethyl ketone, and cyclohexanone, and examples of the aqueous medium include water, an organic solvent miscible with water, and a mixture thereof.

Examples of the water-miscible organic solvent include an alcohol solvent such as methanol, ethanol, n-propanol, isopropanol, ethyl carbitol, ethyl cellosolve and butyl cellosolve; a ketone solvent such as acetone and methyl ethyl ketone; an alkylene glycol solvent such as ethylene glycol, diethylene glycol, propylene glycol; a polyalkylene glycol solvent such as polyethylene glycol, polypropylene glycol, polytetramethylene glycol; and a lactam solvent such as N-methyl-2-pyrrolidone.

Further, the resin forming the primer layer (B) may have a functional group that contributes to a crosslinking reaction, such as an alkoxysilyl group, a silanol group, a hydroxyl group, and an amino group, if necessary. The crosslinked structure formed by using the functional group may be already formed before the step of forming the metal particle layer (M1), which is the subsequent step, and the crosslinked structure may be formed after the step of forming the metal particle layer (M1) . In a case where the crosslinked structure is formed after the step of forming the metal particle layer (M1), the crosslinked structure may be formed in the primer layer (B) before forming the metal pattern layer (M2), and the crosslinked structure may be formed in the primer layer (B), for example, by aging, after forming the metal pattern layer (M2).

If necessary, known agents such as a crosslinking agent, a pH adjusting agent, a film forming aid, a leveling agent, a thickening agent, a water repellent, and a defoaming agent may be appropriately added to the primer layer (B) to be used.

Examples of the crosslinking agent include a metal chelate compound, a polyamine compound, an aziridine compound, a metal salt compound, and an isocyanate compound. A thermal crosslinking agent that performs reaction at a relatively low temperature of about 25°C to 100°C to form a crosslinked structure, a thermal crosslinking agent that performs reaction at a relatively high temperature of 100°C or higher to form a crosslinked structure such as a melamine-based compound, an epoxy-based compound, an oxazoline compound, a carbodiimide compound, and a blocked isocyanate compound, or various photocrosslinking agents may be exemplified.

The used amount of the crosslinking agent differs depending on the type, but from a viewpoint of improving adhesion of the metal pattern layer (M2) to the substrate, the used amount is preferably 0.01 to 60 parts by mass, more preferably 0.1 to 10 parts by mass, and still more preferably 0.1 to 5 parts by mass with respect to 100 parts by mass of the resin contained in the primer.

In a case where the crosslinking agent is used, the crosslinked structure may be already formed before the step of forming the metal particle layer (M1), which is the subsequent step, and the crosslinked structure may be formed after the step of forming the metal particle layer (M1). In a case where the crosslinked structure is formed after the step of forming the metal particle layer (M1), the crosslinked structure may be formed in the primer layer (B) before forming the metal pattern layer (M2), and the crosslinked structure may be formed in the primer layer (B), for example, by aging, after forming the metal pattern layer (M2).

In the present invention, a method for forming the metal particle layer (M1) on the primer layer (B) is the same as the method for forming the metal particle layer (M1) on the insulating substrate (A).

Further, in the same manner as the insulating substrate (A), the primer layer (B) may be surface treated before applying the metal particle dispersion, for the purpose of improving coating ability of the metal particle dispersion and adhesion of the metal pattern layer (M2) to the substrate.

The multilayer body for printed wiring boards of the present invention is a multilayer body in which a photosensitive resin layer (R) for pattern formation is laminated on the metal particle layer (M1).

A method for forming the photosensitive resin layer (R) is not particularly limited and known methods may be used. A liquid photosensitive resist is applied on the metal particle layer (M1) and dried, or a photosensitive dry film resist is thermally pressure-bonded on the substrate on which the metal particle layer (M1) is formed by using a laminator to form a resist layer. Before the resist is formed, the surface of the metal particle layer (M1) may be surface treated such as cleaning treatment by an acidic or alkaline cleaning liquid, corona treatment, plasma treatment, UV treatment, gas phase ozone treatment, liquid phase ozone treatment, and treatment by a surface treating agent, for the purpose of improving adhesion to the resist layer. One method or a combination of two or more methods may be used for the surface treatment.

As the treatment by the surface treating agent, the following may be used: a treatment method using a triazole-based compound, a silane coupling agent, and a rust preventive agent composed of organic acid disclosed in JP-A-7-258870; a treatment method using organic acid, a benzotriazole-based rust preventive agent, and a silane coupling agent disclosed in JP-A-2000-286546; a treatment method using a substance having a structure in which a nitrogen-containing heterocyclic ring such as triazole and thiadiazole and a silyl group such as a trimethoxysilyl group or a triethoxysilyl group are bonded via an organic group having a thioether (sulfide) bond, or the like disclosed in JP-A-2002-363189; a treatment method using a silane compound having a triazine ring and an amino group disclosed in WO2013/186941; a treatment method using an imidazole silane compound obtained by reacting a formyl imidazole compound with an aminopropyl silane compound disclosed in JP-A-2015-214743; a treatment method using an azole silane compound disclosed in JP-A-2016-134454; a treatment method using a solution containing an aromatic compound having an amino group and an aromatic ring in one molecule, polybasic acid having two or more carboxyl groups, and halide ions disclosed in JP-A-2017-203073; and a treatment method using a surface treating agent containing a triazole silane compound disclosed in JP-A-2018-16865.

In order to form a metal pattern on the surface using the multilayer body of the present invention, a photomask is passed through the photosensitive resin layer (R) or the pattern is exposed to active light by using a direct exposure machine. The exposure amount may be appropriately set according to the necessity. The latent image formed on the photosensitive resin layer (R) by exposure is removed by a developing solution to form a pattern resist.

Examples of the developing solution include a dilute alkali aqueous solution such as 0.3% to 2% by mass of sodium carbonate and potassium carbonate. A surfactant, a defoaming agent, and a small amount of an organic solvent, in order to accelerate development, may be added to the diluted alkaline aqueous solution. Further, the exposed substrate is developed by immersing the substrate in the developing solution or spraying the developing solution onto the resist with a spray or the like, and the pattern resist from which the pattern-formed portion is removed can be formed by the development.

When the pattern resist is formed, a descum treatment using plasma may be performed or a resist residue such as resist deposits remaining on a trailing portion generated at the boundary between the cured resist and the substrate or the surface of the substrate may be removed by using a commercially available resist residue remover.

As the resist used for forming the photosensitive resin layer (R) of the present invention, a commercially available resist ink, a liquid resist, and a dry film resist may be used, and the resist may be appropriately selected depending on the targeted pattern resolution, the type of exposure machine to be used, the type of the chemical solution to be used in the plating treatment which is the subsequent step, the pH, or the like.

Examples of commercially available resist ink include the "plating resist MA-830" and "etching resist X-87" manufactured by Taiyo Ink Mfg. Co., Ltd.; the etching resist and plating resist manufactured by NAZDAR Company Inc.; the "etching resist PLAS FINE PER" series and "plating resist PLAS FINE PPR" series manufactured by GOO CHEMICAL CO., LTD. Further, examples of the electrodeposition resist include "Eagle series" and "PEPR series" of The Dow Chemical Company. Further, examples of the commercially available dry films include "PHOTEC" series manufactured by Hitachi Chemical Company, Ltd.; "ALPHO" series manufactured by Nikko-Materials Co., Ltd.; "SUNFORT" series manufactured by Asahi Kasei Corporation; and "RISTON" series manufactured by DuPont de Nemours, Inc.

In a case where a neutral to acidic plating solution is used, it is convenient to use a dry film resist, and in particular, in a case where a fine circuit is formed, a dry film for a semi-additive method may be used. As the commercially available dry film used for the purpose, for example, "ALFO LDF500" and "NIT2700" manufactured by Nikko-Materials Co., Ltd., "SUNFORT UFG-258" manufactured by Asahi Kasei Corporation, and "RD series (RD-2015, 1225)" and "RY series (RY-5319, 5325)" manufactured by Hitachi Chemical Company, Ltd., and "PlateMaster series (PM200, 300)" manufactured by DuPont de Nemours, Inc. may be used.

In a case where an alkaline plating solution such as an electroless copper plating solution is used, a solvent-soluble peeling type resist may be used, or an alkali peeling type resist may be used in a pH and temperature range where the resist is not peeled off.

In a case where a metal pattern on the substrate is formed by using the multilayer body for printed wiring boards of the present invention, the metal pattern layer (M2) may be formed by plating treatment on the metal particle layer (M1) exposed by the development as described above.

Examples of the treatment by the plating method include electroless plating using the metal particle layer (M1) as a plating catalyst, or a combination of the electroless plating and electrolytic plating.

Before forming the metal pattern (M2) by the plating method, the surface of the metal particle layer (M1) may be surface treated, if necessary. As the surface treatment, cleaning treatment using an acidic or alkaline cleaning liquid, corona treatment, plasma treatment, UV treatment, gas phase ozone treatment, liquid phase ozone treatment, and treatment using a surface treating agent, under the condition where the surface of the metal particle layer (M1) and the formed resist pattern are not damaged, may be exemplified. One method or a combination of two or more methods may be used for the surface treatment.

In a case where the metal pattern layer (M2) is formed by electroless plating, examples of the plating metal include copper, nickel, chromium, cobalt, cobalt-tungsten, cobalt-tungsten-boron, and tin. Among the metals, in a case where the metal pattern layer (M2) is used as an electric circuit, copper is preferable because the copper has a low electric resistance. Further, in the present invention, the metal pattern layer (M2) may be formed by performing electrolytic plating after electroless plating. If electrolytic plating is used together, a plating deposition rate may be increased, and accordingly production efficiency is increased, which is advantageous.

In a case where the metal pattern layer (M2) is formed by using both electroless plating and electrolytic plating in the plating step, the deposited metals of electroless plating and electrolytic plating may be the same as or different from each other. For example, a combination such as electrolytic copper plating after electroless copper plating, electrolytic copper plating after electroless nickel plating, electrolytic nickel plating after electroless nickel plating, and electrolytic copper plating after electroless cobalt plating may be exemplified. In a case where the metal pattern layer (M2) is used as a circuit pattern, copper is preferable as the main metal that forms the metal pattern layer (M2) because the copper has a low electric resistance value. Further, it is preferable to combine electroless copper plating with electroless nickel plating or electroless cobalt plating, because diffusion of copper to the substrate can be suppressed and long-term reliability of a circuit can be improved.

In a case where the metal pattern layer (M2) is formed by using electroless plating and electrolytic plating in combination, the thickness of the electroless plated layer may be appropriately selected according to the necessity, and the thickness is preferably 0.1 µm or more and more preferably 0.15 µm or more, because the conductivity for appropriately performing electrolytic plating can be ensured.

In a case where the metal pattern layer (M2) is formed by electrolytic plating, a gap between the metal particles of the metal particle layer (M1) is preferably filled with the metal that constitutes the metal pattern layer (M2). In a case where the gap between the metal particles is filled with the metal that constitutes the metal pattern layer (M2), due to the presence of the metal, the metal particle layer (M1) in the pattern-formed region present below the metal pattern layer (M2) is suppressed from being removed by an etching solution used in the subsequent step. On the other hand, in the metal particle layer (M1) in the non-pattern-formed region, the metal that constitutes the metal pattern layer (M2) is not present between the metal particles, and since the etching solution is likely to permeate into the gap, the layer can be removed by the etching solution with high efficiency. Due to this mechanism, it is possible to suppress undercuts below the metal pattern. In particular, in a case where the metal pattern layer (M2) is used as a circuit pattern, copper is mainly used as the metal that constitutes the circuit pattern. As described below, a use of the etching solution that suppresses etching of copper can further suppress undercuts of the circuit pattern, which is preferable.

When a metal pattern is formed on the insulating substrate by using the multilayer body of the present invention, annealing may be performed after plating for the purpose of stress relaxation of the plating film and improvement of adhesion. The annealing may be performed before the etching step described below or after the etching step, or before and after etching.

The annealing temperature may be appropriately selected in the temperature range of 40°C to 300°C depending on heat resistance or use purpose of the substrate to be used. The annealing temperature is preferably 40°C to 250°C and more preferably 40°C to 200°C for the purpose of suppressing oxidative deterioration of the plating film. Further, the annealing time is preferably 10 minutes to 10 days in a case where the annealing temperature is 40°C to 200°C and preferably about 5 minutes to about 10 hours in a case where the annealing temperature exceeds 200°C. Further, when the plating film is annealed, a rust preventive agent may be appropriately added to the surface of the plating film.

When a metal pattern is formed on the insulating substrate by using the multilayer body of the present invention, the metal pattern layer (M2) is formed by plating, and then a pattern resist formed by using the photosensitive resin layer (R) is peeled off, and the metal particle layer (M1) in the non-pattern-formed portion is removed by an etching solution. The peeling of the pattern resist may be performed under the recommended condition described in catalogs, specifications, or the like of the resist used as the photosensitive resin layer (R). As the resist peeling solution used at the time of peeling the pattern resist, a commercially available resist peeling solution or a 1.5% to 3% by mass aqueous solution of sodium hydroxide or potassium hydroxide set at the temperature of 45°C to 60°C may be used. The resist may be peeled off by immersing the substrate on which the metal pattern layer (M2) is formed in the peeling solution or by spraying the peeling solution with a spray, or the like.

In addition, as the etching solution used at the time of removing the metal particle layer (M1) in the non-pattern-formed portion, it is preferable to use an etching solution which selectively etch only the metal particle layer (M1) and does not etch the metal pattern layer (M2). Here, since silver particles are preferable as the metal particles that constitute the metal particle layer (M1), it is preferable to select the etching solution having a high rate of dissolving silver. Examples of the composition of the etching solution include diluted nitric acid, a mixture of carboxylic acid and hydrogen peroxide, a mixture of ammonia water and hydrogen peroxide, a hydrochloric acid, a mixture of hydrochloric acid and nitric acid, a mixture of sulfuric acid and nitric acid, a mixture of sulfuric acid, nitric acid and organic acid (such as acetic acid), and a mixture of phosphoric acid, nitric acid and organic acid (such as acetic acid).

In a case where the metal pattern layer (M2) is used as a circuit pattern, copper is preferably used as the metal that constitutes the circuit pattern. Here, in a case where silver particles are used as the metal particles that constitute the metal particle layer (M1) and copper is used as the metal that constitutes the metal pattern layer (M2), it is preferable to use an etching solution capable of efficiently removing only silver without etching copper as much as possible, at the time of removing the metal particle layer (M1) of the non-pattern-formed portion. Examples of the etching solution include a mixture of carboxylic acid and hydrogen peroxide.

Examples of the carboxylic acid include acetic acid, formic acid, propionic acid, butyric acid, valeric acid, caproic acid, enanthic acid, caprylic acid, pelargonic acid, capric acid, lauric acid, myristic acid, palmitic acid, margaric acid, stearic acid, oleic acid, linoleic acid, linolenic acid, arachidonic acid, eicosapentaenoic acid, docosahexaenoic acid, oxalic acid, malonic acid, succinic acid, benzoic acid, salicylic acid, phthalic acid, isophthalic acid, terephthalic acid, gallic acid, mellitic acid, cinnamic acid, pyruvic acid, lactic acid, malic acid, citric acid, fumaric acid, maleic acid, aconitic acid, glutaric acid, adipic acid, and amino acid. The carboxylic acids may be used alone or two or more thereof may be used in combination. Among the carboxylic acids, it is preferable to mainly use acetic acid because it is easy to produce and handle the acetic acid as an etching solution.

If a mixture of carboxylic acid and hydrogen peroxide is used as the etching solution, it is considered that percarboxylic acid (peroxycarboxylic acid) is generated by the reaction of hydrogen peroxide with carboxylic acid. It is assumed that the generated percarboxylic acid preferentially dissolves the silver that constitutes the metal particle layer (M1) while suppressing dissolution of the copper that constitutes the metal pattern layer (M2).

As the mixing ratio of the mixture of carboxylic acid and hydrogen peroxide, 2 to 100 mol of hydrogen peroxide is preferable with respect to 1 mol of carboxylic acid and 2 to 50 mol of hydrogen peroxide is more preferable because dissolution of the metal pattern layer (M2) can be suppressed.

The mixture of carboxylic acid and hydrogen peroxide is preferably an aqueous solution diluted with water. Further, the content ratio of the mixture of carboxylic acid and hydrogen peroxide in the aqueous solution is preferably 2% to 65% by mass and more preferably 2% to 30% by mass, because the influence on the temperature rise of the etching solution can be suppressed.

As the water to be used for the dilution, it is preferable to use water from which ionic substances or impurities are removed such as ion-exchanged water, pure water, and ultrapure water.

A protective agent for protecting the metal pattern layer (M2) to suppress dissolution may be further added to the etching solution. In a case where the metal pattern layer (M2) is an electrolytic copper plated layer, it is preferable to use an azole compound as the protective agent.

Examples of the azole compound include imidazole, pyrazole, triazole, tetrazole, oxozole, thiazole, selenazole, oxadiazole, thiadiazole, oxatriazole, and thiatriazole.

Specific examples of the azole compound include 2-methylbenzimidazole, aminotriazole, 1,2,3-benzotriazole, 4-aminobenzotriazole, 1-bisaminomethylbenzotriazole, aminotetrazole, phenyltetrazole, 2-phenylthiazole, and benzothiazole. The azole compounds may be used alone or two or more thereof may be used in combination.

The concentration of the azole compound in the etching solution is preferably 0.001% to 2% by mass and more preferably 0.01% to 0.2% by mass.

Further, in a case where the metal pattern layer (M2) is an electrolytic copper plated layer, polyalkylene glycol is preferably added in the etching solution as the protective agent, because dissolution of the electrolytic copper plated layer can be suppressed.

Examples of the polyalkylene glycol include water-soluble polyalkylene glycol such as polyethylene glycol, polypropylene glycol, and a polyoxyethylene polyoxypropylene block copolymer. Among the water-soluble polyalkylene glycol, polyethylene glycol is preferable. Further, the polyalkylene glycol preferably has the number average molecular weight of 200 to 20,000.

The concentration of the polyalkylene glycol in the etching solution is preferably 0.001% to 2% by mass and more preferably 0.01% to 1% by mass.

An additive such as sodium salts, potassium salts, and ammonium salts of organic acid may be blended in the etching solution, if necessary, in order to suppress the change in pH.

The metal particle layer (M1) in the non-pattern-formed portion in the multilayer body of the present invention may be removed by immersing, in the etching solution, the substrate having the pattern resist formed by using the photosensitive resin layer (R) peeled off, or spraying the etching solution on the substrate using a spray, or the like, after the metal pattern layer (M2) is formed.

In a case where the metal particle layer (M1) in the non-pattern-formed portion is removed by using an etching device, for example, all ingredients of the etching solution may be prepared to have a predetermined composition and then supplied to the etching device. Alternatively, the respective composition of the etching solution may be individually supplied to the etching device and the respective composition may be mixed in the device to prepare the etching solution having a predetermined composition.

The etching solution is preferably used at 10°C to 35°C and, in particular, in a case where the etching solution containing hydrogen peroxide is used, the etching solution is preferably used at 30°C or lower, because decomposition of hydrogen peroxide can be suppressed.

As described above, the printed wiring board of the present invention may be fabricated as follows. A portion in which the metal particle layer (M1) exposed to be a circuit pattern is formed by developing the photosensitive resin layer (R) of the multilayer body for printed wiring boards of the present invention, the portion is subjected to plating to form the metal pattern layer (M2) and then the remaining photosensitive resin layer (R) and the metal particle layer (M1) present below the remaining photosensitive resin layer (R) are removed by etching.

In a case where silver particles are used as the metal particles that constitute the metal particle layer (M1) as described above, the metal particle layer (M1) in the non-pattern-formed portion is removed by the etching solution and then, in addition to cleaning with water, a cleaning operation may be further performed for the purpose of preventing the silver components dissolved in the etching solution from adhering to and remaining on the printed wiring board. For the cleaning operation, it is preferable to use a cleaning solution that dissolves silver oxide, silver sulfide and silver chloride, but hardly dissolves silver. Specifically, it is preferable to use an aqueous solution containing thiosulfate salts or tris(3-hydroxyalkyl) phosphine or an aqueous solution containing mercaptocarboxylic acid or salts thereof as the cleaning chemical solution.

Examples of the thiosulfate salts include ammonium thiosulfate, sodium thiosulfate, and potassium thiosulfate. Examples of the tris(3-hydroxyalkyl) phosphine include tris(3-hydroxymethyl) phosphine, tris(3-hydroxyethyl) phosphine, and tris(3-hydroxypropyl) phosphine. The thiosulfate salts or tris(3-hydroxyalkyl) phosphines may be used alone or two or more thereof may be used in combination.

The concentration in a case where an aqueous solution containing thiosulfate salts is used may be appropriately set depending on the process time and the characteristics of the cleaning device to be used. The concentration is preferably 0.1% to 40% by mass and more preferably 1% to 30% by mass from a viewpoint of cleaning efficiency and stability of the chemical solution during continuous use.

The concentration in a case where an aqueous solution containing tris (3-hydroxyalkyl) phosphine is used may be appropriately set depending on the process time and the characteristics of the cleaning device to be used. The concentration is preferably 0.1% to 50% by mass and more preferably 1% to 40% by mass from a viewpoint of cleaning efficiency and stability of the chemical solution during continuous use.

Examples of the mercaptocarboxylic acid include thioglycolic acid, 2-mercaptopropionic acid, 3-mercaptopropionic acid, thiomalic acid, cysteine, and N-acetylcysteine. Examples of salts of the mercaptocarboxylic acid include alkali metal salts, ammonium salts, and amine salts.

In a case where an aqueous solution of mercaptocarboxylic acid or salts thereof is used, the concentration is preferably 0.1% to 20% by mass and more preferably 0.5% to 15% by mass from a viewpoint of cleaning efficiency and process cost when treating a large amount.

Examples of the method of performing the cleaning operation include a method of immersing the printed wiring board obtained by removing the metal particle layer (M1) in the non-pattern-formed portion by etching into the cleaning chemical solution, and a method of spraying the cleaning chemical solution on the printed wiring board with a spray, or the like. The cleaning chemical solution may be used at room temperature (25°C), but the cleaning chemical solution may be used by setting the temperature, for example, to 30°C, because the cleaning treatment can be stably performed without being affected by the temperature of air outside.

Further, the step of removing the metal particle layer (M1) in the non-pattern-formed portion with an etching solution and the cleaning operation may be repeated according to the necessity.

As described above, as necessary, the printed wiring board of the present invention may be further subjected to the cleaning operation after removing the metal particle layer (M1) of the non-pattern-formed portion with the etching solution, for the purpose of further improving insulating properties of the non-pattern-formed portion. For the cleaning operation, for example, an alkaline permanganic acid solution obtained by dissolving potassium permanganate or sodium permanganate in an aqueous solution of potassium hydroxide or sodium hydroxide may be used.

Examples of the cleaning using the alkaline permanganic acid solution include a method of immersing the printed wiring board obtained by the method in the alkaline permanganic acid solution whose temperature is set to 20°C to 60°C, and a method of spraying the alkaline permanganic acid solution on the printed wiring board with a spray, or the like. The printed wiring board may be treated with a water-soluble organic solvent having an alcoholic hydroxyl group before cleaning, for the purpose of improving the wettability of the alkaline permanganic acid solution to the surface of the substrate and improving cleaning efficiency. Examples of the organic solvent include methyl alcohol, ethyl alcohol, n-propyl alcohol, and isopropyl alcohol. The organic solvents may be used alone or two or more thereof may be used in combination.

The concentration of the alkaline permanganic acid solution may be appropriately selected according to the necessity. The alkaline permanganic acid solution obtained by dissolving 0.1 to 10 parts by mass of potassium permanganate or sodium permanganate in 100 parts by mass of 0.1% to 10% by mass an aqueous solution of potassium hydroxide or sodium hydroxide is preferable, and the alkaline permanganic acid solution obtained by dissolving 1 to 6 parts by mass of potassium permanganate or sodium permanganate in 100 parts by mass of 1% to 6% by mass an aqueous solution of potassium hydroxide or sodium hydroxide is more preferable from a viewpoint of cleaning efficiency.

In a case where cleaning is performed using the alkaline permanganic acid solution, it is preferable to treat the cleaned printed wiring board using a solution having neutralizing and reducing actions after cleaning the alkaline permanganic acid solution. Examples of the solution having neutralizing and reducing actions include an aqueous solution containing 0.5% to 15% by mass of dilute sulfuric acid or organic acid. Examples of the organic acid include formic acid, acetic acid, oxalic acid, citric acid, ascorbic acid, and methionine.

The cleaning with the alkaline permanganic acid solution may be performed after the cleaning which is performed for the purpose of preventing the silver components dissolved in the etching solution from adhering to and remaining on the printed wiring board, or the cleaning with the alkaline permanganic acid solution may be performed alone, instead of the cleaning which is performed for the purpose of preventing the silver components dissolved in the etching solution from adhering to and remaining on the printed wiring board.

Further, the printed wiring board obtained by using the multilayer body for printed wiring boards of the present invention may be appropriately subjected to nickel/gold plating, nickel/palladium/gold plating, or palladium/gold plating according to the necessity, as for formation of a solder resist layer on the circuit pattern and final surface treatment of the circuit pattern.

Due to the multilayer body for printed wiring boards of the present invention, it is possible to produce a substrate having a metal pattern with a satisfactory rectangular cross-sectional shape and high adhesion to various smooth substrates without using a vacuum device. Accordingly, by using the multilayer body for printed wiring boards of the present invention, it is possible to satisfactorily provide a substrate for printed wiring boards and a printed wiring board having various shapes, high density in size, and high performance at low cost, and the printed wiring board has high industrial applicability in the field of printed wiring boards. Further, not only the printed wiring board but also various members having a patterned metal layer on the surface of a substrate such as a connector, an electromagnetic wave shield, an antenna such as RFID, a film condenser, and the like may be produced by using the multilayer body. Furthermore, it is possible to appropriately use the multilayer body for printed wiring boards of the present invention for decorative plating applications having a patterned metal layer on a substrate having various shapes and sizes.

### Examples

Hereinafter, the present invention will be described in detail with reference to examples.

### [Production Example 1: Production of Primer (B-1)]

100 parts by mass of polyester polyol (polyester polyol obtained by reacting 1,4-cyclohexanedimethanol, neopentyl glycol, and adipic acid), 17.6 parts by mass of 2,2-dimethylolpropionic acid, 21.7 parts by mass of 1,4-cyclohexanedimethanol, and 106.2 parts by mass of dicyclohexylmethane-4,4'-diisocyanate were reacted with each other in a mixed solvent of 178 parts by mass of methyl ethyl ketone in a nitrogen-substituted container equipped with a thermometer, a nitrogen gas introduction tube, and a stirrer to obtain a urethane prepolymer solution having an isocyanate group at the terminal.

Subsequently, 13.3 parts by mass of triethylamine was added to the urethane prepolymer solution to neutralize the carboxyl group contained in the urethane prepolymer, and 380 parts by mass of water was further added thereto and the mixture was sufficiently stirred to obtain an aqueous dispersion of the urethane prepolymer.

The urethane prepolymer was chain-extended by adding 8.8 parts by mass of a 25% by mass ethylenediamine aqueous solution to the aqueous dispersion of the urethane prepolymer obtained above and stirring the mixture. Subsequently, an aqueous dispersion of a urethane resin (nonvolatile content: 30% by mass) was obtained by aging and solvent removal. The urethane resin has the weight average molecular weight of 53,000.

Next, 140 parts by mass of deionized water and 100 parts by mass of the aqueous dispersion of the urethane resin obtained above were added to a reaction vessel equipped with a stirrer, a reflux condenser, a nitrogen introduction tube, a thermometer, a dropping funnel for dropping a monomer mixture, and a dropping funnel for dropping a polymerization catalyst, and the temperature was raised to 80°C while blowing nitrogen. Thereafter, while stirring, a monomer mixture composed of 60 parts by mass of methyl methacrylate, 30 parts by mass of n-butyl acrylate and 10 parts by mass of N-n-butoxymethylacrylamide, and 20 parts by mass of a 0.5% by mass ammonium persulfate aqueous solution were added dropwise from separate dropping funnels over 120 minutes while maintaining the temperature inside the reaction vessel at 80°C.

After the dropping is completed, the mixture was further stirred at the same temperature for 60 minutes, and then the temperature inside the reaction vessel was cooled down to 40°C, and the mixture was diluted with deionized water so that the nonvolatile content is 20% by mass. Thereafter, the mixture was filtered by a 200 mesh filter cloth to obtain an aqueous dispersion of a resin composition for a primer layer, which is a core-shell type composite resin having an acrylic resin using methyl methacrylate or the like as a raw material as a core layer and having the urethane resin as a shell layer. Next, isopropyl alcohol and deionized water were added to the aqueous dispersion and mixed so that the mass ratio of isopropanol to water is 7/3 and the nonvolatile content is 2 % by mass, thereby obtaining a primer (B-1).

### [Production Example 2: Production of Primer (B-2)]

200 parts by mass of water and 350 parts by mass of methanol were added to 600 parts by mass of formalin containing 37% by mass of formaldehyde and 7% by mass of methanol in a reaction flask equipped with a reflux condenser, a thermometer and a stirrer. Next, 25% by mass of a sodium hydroxide aqueous solution was added to the aqueous solution to adjust the pH to 10, and then 310 parts by mass of melamine was added thereto and the solution temperature was raised to 85°C to carry out a methylolation reaction for 1 hour.

Thereafter, formic acid was added to adjust the pH to 7, and then the temperature was cooled down to 60°C to carry out an etherification reaction (secondary reaction). 25% by mass of a sodium hydroxide aqueous solution was added at turbidity temperature of 40°C to adjust the pH to 9, and the etherification reaction (reaction time: 1 hour) was stopped. The residual methanol was removed under reduced pressure at the temperature of 50°C (methanol removal time: 4 hours) to obtain a resin composition for a primer containing a melamine resin having a nonvolatile content of 80% by mass. Next, methyl ethyl ketone was added to the resin composition and diluted and mixed to obtain a primer (B-2) having a nonvolatile content of 2% by mass.

### [Production Example 3: Production of Primer (B-3)]

9.2 parts by mass of 2,2-dimethylolpropionic acid, 57.4 parts by mass of polymethylene polyphenyl polyisocyanate ("Millionate MR-200" manufactured by TOSOH Corporation), and 233 parts by mass of methyl ethyl ketone were prepared in a nitrogen-substituted reaction vessel equipped with a thermometer, a nitrogen gas introduction tube, and a stirrer, and reacted at 70°C for 6 hours to obtain an isocyanate compound. Next, 26.4 parts by mass of phenol was supplied as a blocking agent into the reaction vessel and the mixture was reacted at 70°C for 6 hours. Thereafter, the mixture was cooled down to 40°C to obtain a blocked isocyanate solution.

Next, 7 parts by mass of triethylamine was added at 40°C to the blocked isocyanate solution obtained above to neutralize the carboxyl group contained in the blocked isocyanate, and water was added and the mixture was sufficiently stirred. Thereafter, methyl ethyl ketone was distilled off to obtain a resin composition for a primer layer containing the blocked isocyanate having a nonvolatile content of 20% by mass and water. Next, the resin composition was diluted and mixed by adding methyl ethyl ketone, and a primer (B-3) having a nonvolatile content of 2% by mass was obtained.

### [Production Example 4: Production of Primer (B-4)]

35 parts by mass of a novolac resin ("PHENOLITE TD-2131" manufactured by DIC Corporation, hydroxyl equivalent 104 g/equivalent), 64 parts by mass of an epoxy resin ("EPICLON 850-S" manufactured by DIC Corporation; bisphenol A type epoxy resin, epoxy equivalent 188 g/equivalent), and 1 part by mass of 2,4-diamino-6-vinyl-s-triazine ("VT" manufactured by SHIKOKU CHEMICALS CORPORATION) were mixed with each other, and then the mixture was diluted by mixing with methyl ethyl ketone to obtain a primer (B-4) having a nonvolatile content of 2% by mass.

### [Production Example 5: Production of Primer (B-5)]

35 parts by mass of a novolac resin ("PHENOLITE TD-2131" manufactured by DIC Corporation, hydroxyl equivalent 104 g/equivalent), 64 parts by mass of an epoxy resin ("EPICLON 850-S" manufactured by DIC Corporation; bisphenol A type epoxy resin, epoxy equivalent 188 g/equivalent), and 1 part by mass of a silane coupling agent having a triazine ring ("VD-5" manufactured by SHIKOKU CHEMICALS CORPORATION) are mixed with each other, and then the mixture was diluted by mixing with methyl ethyl ketone to obtain a primer (B-5) having a nonvolatile content of 2% by mass.

### [Production Example 6: Production of Primer (B-6)]

750 parts by mass of phenol, 75 parts by mass of melamine, 346 parts by mass of 41.5% by mass formalin, and 1.5 parts by mass of triethylamine were added to a flask equipped with a thermometer, a cooling tube, a fractionating column, and a stirrer, and the temperature was raised to 100°C while paying attention to heat generation. After the reaction was carried out at 100°C for 2 hours under reflux, the temperature was raised to 180°C taking 2 hours while removing water under normal pressure. Next, unreacted phenol was removed under reduced pressure to obtain an aminotriazine-modified novolac resin. The hydroxyl equivalent was 120 g/equivalent.

65 parts by mass of the aminotriazine novolac resin obtained above and 35 parts by mass of an epoxy resin ("EPICLON 850-S" manufactured by DIC Corporation; bisphenol A type epoxy resin, epoxy equivalent 188 g/equivalent) were mixed with each other, and then the mixture was diluted by mixing with methyl ethyl ketone to obtain a primer composition (B-6) having a nonvolatile content of 2% by mass.

### [Production Example 7: Production of Primer (B-7)]

48 parts by mass of the aminotriazine novolac resin obtained in Production Example 6 and 52 parts by mass of an epoxy resin ("EPICLON 850-S" manufactured by DIC Corporation; bisphenol A type epoxy resin, epoxy equivalent 188 g/equivalent) were mixed with each other, and then the mixture was diluted by mixing with methyl ethyl ketone to obtain a primer composition (B-7) having a nonvolatile content of 2% by mass.

### [Production Example 8: Production of Primer (B-8)]

A primer composition (B-8) having a nonvolatile content of 2% by mass was obtained in the same manner as Production Example 7 except that the amounts of the aminotriazine novolac resin and the epoxy resin were changed from 48 parts by mass to 39 parts by mass and from 52 parts by mass to 61 parts by mass, respectively.

### [Production Example 9: Production of Primer (B-9)]

A primer composition (B-9) having a nonvolatile content of 2% by mass was obtained in the same manner as Production Example 8 except that the amounts of the aminotriazine novolac resin and the epoxy resin were changed from 48 parts by mass to 31 parts by mass and from 52 parts by mass to 69 parts by mass, respectively.

### [Production Example 10: Production of Primer (B-10)]

47 parts by mass of the aminotriazine novolac resin obtained in Production Example 7 and 52 parts by mass of an epoxy resin ("EPICLON 850-S" manufactured by DIC Corporation; bisphenol A type epoxy resin, epoxy equivalent 188 g/equivalent) were further mixed with 1 part by mass of anhydrous trimellitic acid, and then the mixture was diluted by mixing with methyl ethyl ketone to obtain a primer (B-10) having a nonvolatile content of 2% by mass.

### [Production Example 11: Production of Primer (B-11)]

350 parts by mass of deionized water and 4 parts by mass of a surfactant ("LATEMUL E-118B" manufactured by Kao Corporation: active ingredient 25% by mass) were added to a reaction vessel equipped with a stirrer, a reflux condenser, a nitrogen introduction tube, a thermometer, and a dropping funnel, and the temperature was raised to 70°C while blowing nitrogen.

A vinyl monomer mixture composed of 47.0 parts by mass of methyl methacrylate, 5.0 parts by mass of glycidyl methacrylate, 45.0 parts by mass of n-butyl acrylate, and 3.0 parts by mass of methacrylic acid, 4 parts by mass of a surfactant ("Aqualon KH-1025" manufactured by DKS Co. Ltd.: active ingredient 25% by mass), and 15 parts by mass of deionized water were mixed with each other to obtain a monomer pre-emulsion. Apart (5 parts by mass) of the obtained monomer pre-emulsion was added to a reaction vessel under stirring, subsequently 0.1 parts by mass of potassium persulfate was added thereto, and polymerization was carried out for 60 minutes while maintaining the temperature in the reaction vessel at 70°C.

Next, while maintaining the temperature in the reaction vessel at 70°C, the remaining monomer pre-emulsion (114 parts by mass) and 30 parts by mass of a potassium persulfate aqueous solution (active ingredient 1.0% by mass) were added dropwise over 180 minutes by using a separate dropping funnel. After the dropping is completed, the mixture was stirred at the same temperature for 60 minutes.

The temperature in the reaction vessel was cooled down to 40°C, subsequently, deionized water was used so that a nonvolatile content is 10.0% by mass, and then the mixture was filtered by a 200 mesh filter cloth to obtain a resin composition for a primer layer used in the present invention. Next, the resin composition was diluted by mixing with water to obtain a primer (B-11) having a nonvolatile content of 5% by mass.

### [Preparation Example 1: Preparation of Silver Particle Dispersion]

Silver particles having an average particle size of 30 nm were dispersed in a mixed solvent of 45 parts by mass of ethylene glycol and 55 parts by mass of ion-exchanged water by using a compound obtained by adding polyoxyethylene to polyethyleneimine as a dispersant to prepare a dispersion containing silver particles and the dispersant. Next, ion-exchanged water, ethanol, and a surfactant were added to the obtained dispersion to prepare 5% by mass of a silver particle dispersion.

### [Preparation Example 2: Preparation of Etching Solution for Silver (1)]

2.6 parts by mass of acetic acid was added to 47.4 parts by mass of water, and 50 parts by mass of 35% by mass hydrogen peroxide solution was further added thereto to prepare an etching solution for silver (1). The molar ratio of hydrogen peroxide to carboxylic acid (hydrogen peroxide/carboxylic acid) in the etching solution for silver (1) was 13.6, and the content ratio of the mixture of hydrogen peroxide and carboxylic acid in the etching solution for silver (1) was 22.4% by mass.

### [Preparation Example 3: Preparation of Etching Solution for Silver (2)]

100 parts by mass of the etching solution for silver (1) obtained in Preparation Example 2 was added with 100 parts by mass of water and diluted to prepare an etching solution for silver (2). The molar ratio of hydrogen peroxide to carboxylic acid (hydrogen peroxide/carboxylic acid) in the etching solution for silver (2) was 13.6, and the content ratio of the mixture of hydrogen peroxide and carboxylic acid in the etching solution for silver (2) was 11.2% by mass.

### [Fabrication Example 1: Fabrication of Polyphenylene Sulfide (PPS) Substrate]

100 parts by mass of linear polyphenylene sulfide (MFR according to ASTM D1238-86: 600 g/10 min), 58.8 parts by mass of a chopped glass fiber ("FT562" manufactured by Asahi Fiber Glass Co., Ltd., fibrous inorganic filler), 8.4 parts by mass of an ethylene-methacrylic acid copolymer zinc ion type ("HIMILAN 1855" manufactured by DuPont-Mitsui Polychemicals Co. Ltd.), and 0.8 parts by mass of montanic acid complex ester wax ("Licolub WE40" manufactured by Clariant (Japan) K.K.) were uniformly mixed with each other, and then the mixture was melt-kneaded at 290°C to 330°C using a 35 mmφ twin-screw extruder to obtain a polyphenylene sulfide resin composition. The obtained polyphenylene sulfide resin composition was molded by an injection molding machine to fabricate a PPS substrate having a size of 50 mm × 105 mm × 2 mm.

### (Example 1)

The silver particle dispersion obtained in Preparation Example 1 was applied on the surface of a polyimide film ("Kapton 150EN-C" manufactured by DU PONT-TORAY CO., LTD.; thickness: 38 µm) by using a desktop type small coater ("K printing proofer" manufactured by RK Print Coat Instruments Ltd) so that the coating amount after drying is 0.05 g/m². Next, drying was performed at 80°C for 5 minutes using a hot air dryer to form a silver particle layer on the surface of the polyimide film.

A dry film resist ("Photec RD-1225" manufactured by Hitachi Chemical Company, Ltd.; resist film thickness 25 µm) was pressure-bonded onto the silver particle layer at 100°C by using a roll laminator to fabricate a multilayer body in which a silver particle layer and a photosensitive resin layer were laminated on the polyimide substrate.

### (Fabrication Example of Printed Wiring Board using Multilayer Body of Example 1)

The multilayer body obtained above was used, and a comb-shape pattern of L/S = 50/50 µm was exposed on the resist using a direct exposure digital imaging device ("Nuvogo 1000R" manufactured by Orbotech Ltd.). Next, development was performed using 1% by mass of a sodium carbonate aqueous solution to form a pattern resist in which a comb-shape electrode pattern portion was removed on the silver particle layer, and the silver particle layer on the polyimide film was exposed.

Next, the substrate on which the pattern resist is formed was aged at 100°C for 1 hour, and then immersed in an electroless copper plating solution ("THRU-CUP PEA-6" manufactured by Uyemura & Co.,Ltd.) at 36°C for 10 minutes to form an electroless copper plating film (thickness 0.4 µm). Next, the surface of the electroless copper plating obtained above was set as a cathode and the phosphorus-containing copper was set as an anode to perform electrolytic plating at the current density of 2.5 A/dm² for 20 minutes by using an electrolytic plating solution containing copper sulfate (copper sulfate 70 g/L, sulfuric acid 200 g/L, chloride ions 50 mg/L, and an additive ("TOP LUCINA SF-M" manufactured by OKUNO CHEMICAL INDUSTRIES CO., LTD.). Accordingly, a comb-shape electrode made of a metal pattern layer (film thickness 10 µm) was formed on the pattern portion in which the resist is removed by electrolytic copper plating. Next, the film in which a copper metal pattern is formed was immersed in 3% by mass of a sodium hydroxide aqueous solution set to have the temperature of 50°C to peel off the pattern resist.

Next, the film obtained above was immersed in the etching solution for silver (1) obtained in Preparation Example 2 at 25°C for 30 seconds to remove the silver particle layer other than the comb-shape electrode portion to obtain a printed wiring board. The cross-sectional shape of the circuit-formed portion (comb-shape electrode portion) of the fabricated printed wiring board was rectangular without undercuts.

### (Example 2)

A multilayer body in which the silver particle layer and the photosensitive resin layer are laminated on the polyimide film was fabricated in the same manner as Example 1 except that the coating amount of the silver particle layer after drying was changed from 0.05 g/m² to 0.3 g/m².

### (Fabrication of Printed Wiring Board using Multilayer Body of Example 2)

From the exposure and development to the peeling of the pattern resist, the same was performed as the Fabrication Example in which the multilayer body of Example 1 is used, a comb-shape electrode made of a copper metal pattern layer is formed on the polyimide film by immersing the film in the etching solution for silver (1) obtained in Preparation Example 2 at 25°C for 3 minutes to obtain a printed wiring board. The cross-sectional shape of the circuit-formed portion (comb-shape electrode portion) of the fabricated printed wiring board was rectangular without undercuts.

### (Example 3)

The primer (B-1) obtained in Production Example 1 was applied on the surface of a polyimide film ("Kapton 150EN-C" manufactured by DU PONT-TORAY CO., LTD.; thickness: 38 µm) by using a desktop type small coater ("K printing proofer" manufactured by RK Print Coat Instruments Ltd) so that the thickness after drying is 100 nm. Next, drying was performed at 80°C for 5 minutes using a hot air dryer to form a primer layer on the surface of the polyimide film.

Next, the silver particle dispersion obtained in Preparation Example 1 was applied on the surface of the primer layer by using a desktop type small coater ("K printing proofer" manufactured by RK Print Coat Instruments Ltd) so that the coating amount after drying is 0.1 g/m², and drying was performed at 200°C for 30 minutes using a hot air dryer to form a silver particle layer containing silver particles on the surface of the primer layer. After the silver particle layer was formed, a multilayer body in which a primer layer, a silver particle layer, and a photosensitive resin layer were laminated on a polyimide film was fabricated in the same manner as Example 1.

### (Fabrication of Printed Wiring Board using Multilayer Body of Example 3)

A printed wiring board was obtained in the same manner as Example 2. The cross-sectional shape of the circuit-formed portion (comb-shape electrode portion) of the fabricated printed wiring board was rectangular without undercuts.

### (Example 4)

A multilayer body in which a silver particle layer and a photosensitive resin layer were laminated on a polyimide film was fabricated in the same manner as Example 3 except that the coating amount of the silver particle layer after drying was changed from 0.1 g/m² to 3 g/m², and the time for immersing the film in the etching solution for silver (1) was changed from 3 minutes to 5 minutes.

### (Fabrication Example of Printed Wiring Board using Multilayer Body of Example 4)

A pattern resist was formed in the same manner as Example 3 to expose the surface of the silver particle layer in the pattern-formed region. Next, the exposed silver particle layer was set as a cathode and the phosphorus-containing copper was set as an anode to perform electrolytic plating at the current density of 2.5 A/dm² for 20 minutes by using an electrolytic plating solution containing copper sulfate (copper sulfate 70 g/L, sulfuric acid 200 g/L, chloride ions 50 mg/L, and an additive ("TOP LUCINA SF-M" manufactured by OKUNO CHEMICAL INDUSTRIES CO., LTD.). Accordingly, a metal pattern (film thickness 10 µm) was formed on the pattern portion in which a resist was removed by electrolytic copper plating.

From the exposure and development to the peeling of the pattern resist, the same was performed as the Fabrication Example in which the multilayer body of Example 1 was used, a comb-shape electrode made of a copper metal pattern layer was formed on the polyimide film by immersing the film in the etching solution for silver (1) obtained in Preparation Example 2 at 25°C for 10 minutes to obtain a printed wiring board. The cross-sectional shape of the circuit-formed portion (comb-shape electrode portion) of the fabricated printed wiring board was rectangular without undercuts.

### (Examples 5 to 14)

Multilayer bodies were obtained in the same manner as Example 3 except that the type of primer used for the primer layer and the drying conditions thereof, the film thickness of the silver particle layer, and the etching solution were changed to those shown in Table 1 or 2. The cross-sectional shapes of the circuit-formed portions (comb-shape electrode portions) of the printed wiring boards fabricated using the multilayer bodies were rectangular without undercuts.

### (Example 15)

The PPS substrate obtained in Fabrication Example 1 was used and the PPS substrate was immersed in the primer (B-11) obtained in Production Example 11 for 10 seconds. Thereafter, the PPS substrate was taken out and placed standstill for 1 minute, and then dried at 80°C for 5 minutes using a hot air dryer to form a primer resin layer (thickness 130 nm) on the PPS substrate.

Next, the PPS substrate on which the primer layer is formed was immersed in a solution for 10 seconds, the solution is obtained by diluting the silver particle dispersion obtained in Preparation Example 1 using ion-exchanged water and ethanol, the mass ratio of the solvents after dilution is water: ethanol = 1: 1, and the concentration of the silver particles is adjusted to be 1% by mass. Thereafter, the PPS substrate was taken out and placed standstill for 1 minute, and then dried at 80°C for 5 minutes using a hot air dryer to form a silver particle layer of 0.1 g/m² on the primer layer.

A dry film resist ("Photec RD-1225" manufactured by Hitachi Chemical Company, Ltd.; resist film thickness 25 µm) was pressure-bonded onto the silver particle layer at 100°C by using a vacuum laminator to fabricate a multilayer body in which a primer layer, a silver particle layer and a photosensitive resin layer were laminated on the PPS substrate.

### (Fabrication Example of Printed Wiring Board using Multilayer Body of Example 15)

The multilayer body obtained above was used and the same was performed as "Fabrication Example of Printed Wiring Board using Multilayer Body of Example 2" to obtain a printed wiring board. The cross-sectional shape of the circuit-formed portion (comb-shape electrode portion) of the fabricated printed wiring board was rectangular without undercuts.

### (Example 16)

16% by mass of an aqueous dispersion of the copper particles having the average particle size of 108 nm, which was measured by a dynamic light scattering method, was obtained based on Synthesis Example 36 of International Publication No. 2014/045972. Isopropanol was added to the aqueous dispersion to prepare 5% by mass of a copper particle dispersion, and the dispersion was applied on the surface of the polyimide film so that the weight after drying is 0.5 g/m² in the same manner as Example 1. Next, a metal layer containing copper particles was formed on the surface of the polyimide film by drying the film at 200°C for 30 minutes under a nitrogen stream using a hot air dryer.

Next, a dry film resist ("Photec RD-1225" manufactured by Hitachi Chemical Company, Ltd.; resist film thickness 25 µm) was pressure-bonded onto the metal layer containing copper particles at 100°C by using a roll laminator to fabricate a multilayer body in which a copper particle layer and a photosensitive resin layer were laminated on the polyimide substrate.

### (Fabrication Example of Printed Wiring Board using Multilayer body of Example 16)

The multilayer body obtained by performing the same as "Fabrication Example of Printed Wiring Board using Multilayer Body of Example 2" and peeling the pattern resist was immersed in 2% by mass of a sodium persulfate aqueous solution for 10 minutes, and as a result, the copper particle layer other than the comb-shape electrode portion was removed. Etching was performed even in the bottom of the comb-electrode portion and undercuts were generated.

Regarding the printed wiring boards fabricated using the multilayer body obtained in the Examples 1 to 16, the following methods were used to check conduction between wirings by a tester, measure insulation resistance, measure insulation resistance of the non-circuit-formed portion, measure peel strength, and check the presence or absence of undercuts and the cross-sectional shape of the circuit-formed portion (comb-shape electrode portion).

### [Measurement of Insulation Resistance between wirings]

Regarding the printed wiring board obtained above, the presence or absence of conduction between the comb-shape electrodes opposing in the space of 50 µm was checked by a tester ("233 remote display digital multimeter, manufactured by Fluke Corporation") . As a result, a printed wiring board in which the silver particle layer was not sufficiently removed and conduction was recognized is defined as "short circuit" and a printed wiring board in which the silver particle layer was sufficiently removed and conduction was not recognized is defined as "insulation". Next, regarding the printed wiring board in which conduction was not recognized, a resistance value between the electrodes in the space of 50 µm was measured in the same manner by using a super megohmmeter (SM-8213) manufactured by HIOKI E.E. CORPORATION. Here, it can be said that the printed wiring board having the resistance value of exceeding 10⁶ Ω has sufficient insulation between the wirings.

### [Measurement of Insulation Resistance of Non-Circuit-Formed Portion]

Regarding the non-circuit-formed portion (region other than the comb-shape electrode portion) of the printed wiring board obtained above, a resistance value when 100 V was applied was measured by using Hiresta-UP (MCP-HT450 type) manufactured by Mitsubishi Chemical Analytech Co., Ltd. In addition, a case where the resistance value is "over range" means that the resistance value is 9.99 × 10¹³ Ω or more according to the specifications of the measurement device.

### [Check Presence or Absence of Undercuts and Cross-Sectional Shape of Comb-shape Electrode Portion]

The cross-section of the comb-shape electrode portion of the printed wiring board obtained above was magnified 500 to 10, 000 times with a scanning electron microscope ("JSM7800" manufactured by JEOL Ltd.) and observed, and the presence or absence of undercuts and the cross-sectional shape of the comb-shape electrode portion were checked.

### [Measurement of Peel Strength]

A linear pattern having a width of 1 cm was formed on the photosensitive resin layer (R) to fabricate a test piece having a line width of 1 cm and a film thickness of the copper plating layer of 15 µm. The produced test piece was subjected to a peel test in the direction of 90° by using "Multi Bond Tester SS-30WD" manufactured by Seishin Trading Co., Ltd. to measure the peel strength.

Tables 1 and 2 show a summary of the measurement results of the printed wiring boards obtained in Examples 1 to 16. The abbreviations for the metal pattern forming method and the etching solution are as follows.
I: Electroless plating + Electrolytic plating
II: Electrolytic plating
A: Silver etching solution (1) (content ratio of the mixture of hydrogen peroxide and acetic acid is 22.4% by mass)
B: Silver etching solution (2) (content ratio of the mixture of hydrogen peroxide and acetic acid is 11.2% by mass)
C: 2% by mass sodium persulfate aqueous solution

**[Table 1]**

| | Example 1 | Example 2 | Example 3 | Example 4 | Example 5 | Example 6 | Example 7 | Example 8 |
|---|---|---|---|---|---|---|---|---|
| Insulating substrate | Polyimide film | Polyimide film | Polyimide film | Polyimide film | Polyimide film | Polyimide film | Polyimide film | Polyimide film |
| Type of primer | None | None | B-1 | B-1 | B-1 | B-2 | B-3 | B-4 |
| Coating Method of primer | - | - | Coater | Coater | Coater | Coater | Coater | Coater |
| Drying temperature of primer (°C) | - | - | 80 | 80 | 80 | 120 | 120 | 150 |
| Drying time of primer (min) | - | - | 5 | 5 | 5 | 5 | 5 | 5 |
| Metal particles constituting metal particle laver | Silver | Silver | Silver | Silver | Silver | Silver | Silver | Silver |
| Formation amount of metal particle layer (g/m²) | 0.05 | 0.3 | 0.1 | 3 | 0.1 | 0.5 | 0.5 | 0.5 |
| Metal constituting metal pattern layer | Copper | Copper | Copper | Copper | Copper | Copper | Copper | Copper |
| Method of forming metal pattern layer | I | I | I | II | I | I | I | I |
| Etching solution | A | A | A | A | B | A | A | A |
| Molar ratio of hydrogen peroxide to carboxylic acid | 13.6 | 13.6 | 13.6 | 13.6 | 13.6 | 13.6 | 13.6 | 13.6 |
| Checking of conduction between wirinas | Insulation | Insulation | Insulation | Insulation | Insulation | Insulation | Insulation | Insulation |
| Resistance value between wirings (Ω) | > 10¹¹ | >10¹¹ | > 10¹¹ | > 10¹¹ | > 10¹¹ | >10¹¹ | > 10¹¹ | > 10¹¹ |
| Resistance value of non-circuit-formed portion (Ω) | Over range | Over range | Over range | Over range | Over range | Over range | Over range | Over range |
| Presence or absence of undercuts | None | None | None | None | None | None | None | None |
| Cross-sectional shape of circuit-formed portion | Rectangular | Rectangular | Rectangular | Rectangular | Rectangular | Rectangular | Rectangular | Rectangular |
| 90° Peel strength (N/m) | 657 | 617 | 725 | 710 | 760 | 731 | 795 | 761 |

**[Table 2]**

| | Example 9 | Example 10 | Example 11 | Example 12 | Example 13 | Example 14 | Example 15 | Example 16 |
|---|---|---|---|---|---|---|---|---|
| Insulating substrate | Polyimide film | Polyimide film | Polyimide film | Polyimide film | Polyimide film | Polyimide film | PPS substrate | Polyimide film |
| Type of primer | B-5 | B-6 | B-7 | B-8 | B-9 | B-10 | B-11 | None |
| Coating Method of primer | Coater | Coater | Coater | Coater | Coater | Coater | Immersion | - |
| Drying temperature of primer (°C) | 150 | 150 | 150 | 150 | 150 | 150 | 200 | - |
| Drying time of primer (min) | 5 | 5 | 5 | 5 | 5 | 5 | 5 | - |
| Metal particles constituting metal particle layer | Silver | Silver | Silver | Silver | Silver | Silver | Silver | Copper |
| Formation amount of metal particle layer (g/m²) | 0.5 | 0.5 | 0.5 | 0.5 | 0.5 | 0.5 | 0.5 | 0.5 |
| Metal constituting metal pattern layer | Copper | Copper | Copper | Copper | Copper | Copper | Copper | Copper |
| Method of forming metal pattern layer | I | I | I | I | I | I | I | I |
| Etching solution | A | A | A | A | A | A | A | C |
| Molar ratio of hydrogen peroxide to carboxylic acid | 13.6 | 13.6 | 13.6 | 13.6 | 13.6 | 13.6 | 13.6 | - |
| Checking of conduction between wirings | Insulation | Insulation | Insulation | Insulation | Insulation | Insulation | Insulation | Insulation |
| Resistance value between wirings (Q) | > 10¹¹ | >10¹¹ | > 10¹¹ | >10¹¹ | > 10¹¹ | >10¹¹ | > 10¹¹ | >10¹¹ |
| Resistance value of non-circuit-formed portion (Q) | Over range | Over range | Over range | Over range | Over range | Over range | Over range | Over range |
| Presence or absence of undercuts | None | None | None | None | None | None | None | Yes |
| Cross-sectional shape of circuit-formed portion | Rectangular | Rectangular | Rectangular | Rectangular | Rectangular | Rectangular | Rectangular | Non-rectangular |
| 90° Peel strength (N/m) | 838 | 838 | 730 | 690 | 535 | 723 | 785 | 605 |

## Claims

1. A multilayer body for a printed wiring board comprising a metal particle layer (M1) and a photosensitive resin layer (R) that are sequentially laminated on an insulating substrate (A) .

2. A multilayer body for a printed wiring board comprising a primer layer (B), a metal particle layer (M1), and a photosensitive resin layer (R) that are sequentially laminated on an insulating substrate (A).

3. The multilayer body for a printed wiring board according to claim 1 or 2, wherein metal particles constituting the metal particle layer (M1) are those coated with a polymeric dispersant.

4. The multilayer body for a printed wiring board according to claim 3, wherein in the multilayer body for printed wiring boards according to claim 2, the primer layer (B) is composed of a resin having a reactive functional group [X], the polymeric dispersant has a reactive functional group [Y], and the reactive functional group [X] and the reactive functional group [Y] are capable of causing reaction to form a chemical bond with each other.

5. The multilayer body for a printed wiring board according to claim 4, wherein the reactive functional group [Y] is a basic nitrogen atom-containing group.

6. The multilayer body for a printed wiring board according to claim 4, wherein the polymeric dispersant having the reactive functional group [Y] is one or more selected from the group consisting of a polyalkyleneimine and a polyalkyleneimine having a polyoxyalkylene structure containing an oxyethylene unit.

7. The multilayer body for a printed wiring board according to any one of claims 4 to 6, wherein the reactive functional group [X] is one or more selected from the group consisting of a keto group, an acetoacetyl group, an epoxy group, a carboxyl group, an N-alkylol group, an isocyanate group, a vinyl group, a (meth)acryloyl group, and an allyl group.

8. The multilayer body for a printed wiring board according to any one of claims 1 to 7, wherein metal particles constituting the metal particle layer (M1) are silver particles.

9. A printed wiring board formed by using the multilayer body for printed wiring boards according to any one of claims 1 to 8.
